(19) Europäisches Patentamt / European Patent Office / Office européen des brevets

(11) **EP 2 340 578 B1**

(12) **EUROPÄISCHE PATENTSCHRIFT**

(45) Veröffentlichungstag und Bekanntmachung des Hinweises auf die Patenterteilung:
**03.12.2014 Patentblatt 2014/49**

(21) Anmeldenummer: **09748959.5**

(22) Anmeldetag: **22.10.2009**

(51) Int Cl.:
***H01L 51/52*** *(2006.01)*

(86) Internationale Anmeldenummer:
**PCT/DE2009/001487**

(87) Internationale Veröffentlichungsnummer:
**WO 2010/048927 (06.05.2010 Gazette 2010/18)**

(54) **ORGANISCHES STRAHLUNGSEMITTIERENDES BAUELEMENT UND VERFAHREN ZUR HERSTELLUNG EINES ORGANISCHEN STRAHLUNGSEMITTIERENDEN BAUELEMENTS**

ORGANIC RADIATION-EMITTING COMPONENT AND METHOD FOR PRODUCING AN ORGANIC RADIATION-EMITTING COMPONENT

COMPOSANT RAYONNANT ORGANIQUE ET PROCÉDÉ DE FABRICATION D'UN COMPOSANT RAYONNANT ORGANIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **31.10.2008 DE 102008054219**

(43) Veröffentlichungstag der Anmeldung:
**06.07.2011 Patentblatt 2011/27**

(73) Patentinhaber: **OSRAM Opto Semiconductors GmbH**
**93055 Regensburg (DE)**

(72) Erfinder:
• **SCHMID, Günter**
**91334 Hemhofen (DE)**
• **KRAUSE, Ralf**
**91058 Erlangen (DE)**

• **SEIDEL, Stefan**
**93152 Nittendorf (DE)**
• **WEISS, Oliver**
**69221 Dossenheim (DE)**
• **GÄRDITZ, Christoph**
**93051 Regensburg (DE)**
• **SUHONEN, Rükka**
**90630 Oulu (FI)**
• **NIEDERMEIER, Ulrich**
**94339 Leiblfing (DE)**

(74) Vertreter: **Epping - Hermann - Fischer Patentanwaltsgesellschaft mbH Schloßschmidstraße 5 80639 München (DE)**

(56) Entgegenhaltungen:
EP-A2- 1 978 574      WO-A1-2008/034405
WO-A2-2006/077136    US-A1- 2007 075 636

**Beschreibung**

Diese Patentanmeldung beansprucht die Priorität der deutschen Patentanmeldung 10 2008 054 219.9.

Im Folgenden werden ein organisches strahlungsemittierendes Bauelement und ein Verfahren zur Herstellung eines organischen strahlungsemittierenden Bauelements angegeben.

In zunehmendem Maße wird die Nutzung von organischen Leichtdioden (OLEDs) für Beleuchtungszwecke diskutiert. Dazu sollen großflächige OLED-Bauelemente mit großflächigen Elektroden zum Einsatz kommen. Ein derartiges OLED-Bauelement weist jedoch üblicherweise das Problem auf, dass die elektrische Leitfähigkeit der großflächigen Elektroden, insbesondere wenn das OLED-Bauelement eine großflächige transparente Elektrode aufweist, sehr begrenzt ist. Durch die materialbedingte beschränkte Leitfähigkeit kommt es zu einer ungleichmäßigen Stromversorgung über die OLED-Fläche, da die Versorgungsspannung lateral über die Fläche der Elektrode abfällt. Damit werden Randbereiche im Vergleich mit Bereichen in der Mitte der OLED besser mit Ladungsträgern versorgt, da ein Spannungsabfall entlang der Elektrodenerstreckungsrichtung erfolgt. Diese Inhomogenität in der Stromverteilung macht sich dann sofort in der Leuchtdichteverteilung der OLED bemerkbar und führt dazu, dass die Helligkeit zur Mitte der OLED hin stark abfällt, was auch als so genannter Badewanneneffekt bezeichnet wird. Bereits 10 bis 20% Helligkeitsunterschied zwischen beispielsweise dem Rand und der Mitte der OLED wirken sich negativ auf das äußere Erscheinungsbild bei bekannten großflächigen OLEDs aus. Eine Vergrößerung der Dicke einer transparenten großflächigen Elektrode würde zwar deren Leitfähigkeit erhöhen, jedoch würde dadurch die Transparenz der Elektrode und damit die Auskoppeleffizienz des in der OLED erzeugten Lichts herabgesetzt werden. Dickere Elektroden sind zudem kostenintensiv.

Die Druckschrift WO 2006/077136 A2 beschreibt eine OLED, die auf einem Substrat eine erste als Anode ausgebildete Elektrodenschicht mit seitlich angeordneten Kontaktierungen aufweist. Darüber ist eine Widerstandsanpassungsschicht angeordnet, die einen in lateraler Richtung variierenden Widerstandsverlauf durch eine Variation der Schichtzusammensetzung aufweist, um eine homogene Leuchtdichteverteilung der darüber angeordneten Elektrolumineszenzschicht zu bewirken.

Die Druckschrift US 2007/0075636 A1 beschreibt ein organisches elektrolumineszierendes Bauelement, das eine Elektroneninjektionsschicht aufweist, die $Alq_3$ als Hauptkomponente und Li als zusätzlichen Bestandteil aufweist, wobei der Anteil von Li mit dem Abstand zu einem Elektrodenanschluss wächst.

Die Druckschrift WO 2008/034405 A1 beschreibt eine OLED, bei der eine erste Ladungstransportschicht einen Dotierstoff umfasst, der eine laterale Dichteschwankung aufweist, wodurch eine lateral variierende Leitfähigkeit der ersten Ladungstransportschicht erzeugt werden kann. Die örtliche Schwankung des Dotierungsgrades führt zu einer Helligkeitsmodifikation in einer darüberliegenden Licht emittierenden Funktionsschicht.

Zumindest eine Aufgabe von bestimmten Ausführungsformen ist es, ein organisches strahlungsemittierendes Bauelement anzugeben, das zumindest eine organische funktionelle Schicht aufweist. Weiterhin ist es eine Aufgabe von bestimmten Ausführungsformen, ein Verfahren zur Herstellung eines solchen organischen strahlungsemittierenden Bauelements anzugeben.

Diese Aufgaben werden durch einen Gegenstand und ein Verfahren mit den Merkmalen der unabhängigen Patentansprüche gelöst. Vorteilhafte Ausführungsformen und Weiterbildungen des Gegenstands und des Verfahrens sind in den abhängigen Ansprüchen gekennzeichnet und gehen weiterhin aus der nachfolgenden Beschreibung und den Zeichnungen hervor.

Ein organisches strahlungsemittierendes Bauelement gemäß einer Ausführungsform umfasst insbesondere

- eine erste Elektrode mit einem ersten elektrischen Kontaktbereich zur elektrischen Kontaktierung der ersten Elektrode,
- auf der ersten Elektrode eine erste organische funktionelle Schicht,
- auf der ersten organischen funktionellen Schicht zumindest einen organischen aktiven Bereich, der geeignet ist, im Betrieb elektromagnetische Strahlung abzustrahlen, und
- auf dem aktiven Bereich eine zweite Elektrode,
  wobei
- die erste organische funktionelle Schicht eine Mehrzahl von lateral angeordneten Teilbereichen mit jeweils einem ersten Material mit einer ersten elektrischen Leitfähigkeit und einem zweiten Material mit einer zweiten elektrischen Leitfähigkeit umfasst,
- die zweite elektrische Leitfähigkeit größer als die erste elektrische Leitfähigkeit ist und
- das Verhältnis des Anteils des zweiten Materials zum Anteil des ersten Materials in den Teilbereichen der ersten organischen funktionellen Schicht in Abhängigkeit von einem lateralen Abstand zum ersten elektrischen Kontaktbereich variiert,

wobei

- jeder der Teilbereiche (30) der ersten organischen funktionellen Schicht (31) einen ersten Funktionsbereich (35) mit dem ersten und dem zweiten Material (51, 52) und einen zweiten Funktionsbereich (36) mit dem ersten Material (51) aufweist,
- die Volumenkonzentration des zweiten Materials (52) im Verhältnis zum ersten Material (51) in den ersten Funktionsbereichen (35) verschiedener Teilbereiche (30) gleich ist und
- der zweite Funktionsbereich (36) der Teilbereiche (30) frei vom zweiten Material (52) ist.

Dass eine Schicht oder ein Element "auf" oder "über" einer anderen Schicht oder einem anderen Element angeordnet oder aufgebracht ist, kann dabei hier und im Folgenden bedeuten, dass die eine Schicht oder das eine Element unmittelbar in direktem mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht beziehungsweise zwischen dem einen und dem anderen Element angeordnet sein.

Dass eine Schicht oder ein Element "zwischen" zwei anderen Schichten oder Elementen angeordnet ist, kann hier und im Folgenden bedeuten, dass die eine Schicht oder das eine Element unmittelbar in direktem mechanischen und/oder elektrischen Kontakt oder in mittelbarem Kontakt zur einen der zwei anderen Schichten oder Elementen und in direktem mechanischen und/oder elektrischen Kontakt oder in mittelbarem Kontakt zur anderen der zwei anderen Schichten oder Elementen angeordnet ist. Dabei können bei mittelbarem Kontakt dann weitere Schichten und/oder Elemente zwischen der einen und zumindest einer der zwei anderen Schichten beziehungsweise zwischen dem einen und zumindest einem der zwei anderen Element angeordnet sein.

Die Bezeichnungen "Strahlung", "elektromagnetische Strahlung" und "Licht" bedeuten hier und im Folgenden elektromagnetische Strahlung mit zumindest einer Wellenlänge beziehungsweise einer spektralen Komponente in einem infraroten bis ultravioletten Wellenlängenbereich. Insbesondere kann infrarotes, sichtbares und/oder ultraviolettes Licht bezeichnet sein.

Ein "elektrischer Kontaktbereich" zur elektrischen Kontaktierung beziehungsweise zum elektrischen Anschluss einer Elektrode kann hier und im Folgenden beispielsweise eine elektrische Zuleitung, eine Leiterbahn, ein elektrisches Anschlusspad, einen Kontaktdraht und/oder ein Bondpad umfassen oder sein und geeignet sein, eine Elektrode elektrisch an eine Spannungs- und/oder Stromversorgung anzuschließen. Dabei kann der elektrische Kontaktbereich auch durch einen Teil der Elektrode gebildet sein. Insbesondere kann der elektrische Kontaktbereich derart angeordnet sein, dass kein direkter elektrischer Kontakt zwischen dem elektrischen Kontaktbereich und organischen funktionellen Schichten, beispielsweise der vorab genannten ersten organischen funktionellen Schicht oder einer der im Folgenden genannten und beschriebenen organischen funktionellen Schichten, vorliegt. Ein elektrischer Kontaktbereich kann insbesondere in lateraler Richtung neben der ersten funktionellen Schicht angeordnet sein. Insbesondere kann das bedeuten, dass ein elektrischer Kontaktbereich zur elektrischen Kontaktierung einer Elektrode nur mit dieser Elektrode in direktem elektrischen Kontakt steht.

Eine "Schicht" kann hier und im Folgenden soweit nicht ausdrücklich anders beschrieben ein Element bedeuten, dessen Abmessungen durch eine Haupterstreckungsrichtung mit zwei Haupterstreckungsrichtungen und eine Dicke beziehungsweise Höhe gekennzeichnet sind, wobei die Dicke beziehungsweise Höhe kleiner als zumindest eine Haupterstreckungsrichtung und bevorzugt kleiner als beide Haupterstreckungsrichtungen ist.

"Lateral" kann hier und im Folgenden eine Richtung und auch eine relative Anordnung von zwei Elementen zueinander bedeuten, die parallel zu zumindest einer Haupterstreckungsrichtung und besonders bevorzugt parallel zur Haupterstreckungsebene der ersten und zweiten Elektrode und der eine organischen funktionellen Schicht verläuft. Eine laterale Richtung kann somit senkrecht zur Anordnungsrichtung der ersten Elektrode, der ersten organischen funktionellen Schicht, des aktiven Bereichs und der zweiten Elektrode übereinander sein. In diesem Sinne kann "übereinander" hier und im Folgenden eine Anordnung entlang einer Richtung denkrecht zur Haupterstreckungsrichtung der Elektroden und weiterer Schichten des organischen strahlungsemittierenden Bauelements bezeichnen und damit durch die Aufbringreihenfolge der Schichten aufeinander definiert sein.

Beim hier beschriebenen organischen strahlungsemittierenden Bauelement kann zum Betrieb eine Spannung beziehungsweise ein Strom zwischen dem ersten elektrischen Kontaktbereich und der zweiten Elektrode angelegt werden. Vereinfacht ausgedrückt ist der partielle Widerstand eines beliebigen gedachten Strompfades vom ersten Kontaktbereich zur zweiten Elektrode durch die Widerstände der jeweiligen entsprechenden Anteile des Strompfades in der ersten Elektrode, in der ersten organischen Schicht, im aktiven Bereich und gegebenenfalls in weiteren Schichten zwischen der ersten und zweiten Elektrode gegeben. Aufgrund aller physikalisch und technisch möglichen Strompfade durch diese Schichten bilden sich im Betrieb des organischen strahlungsemittierenden Bauelements in den einzelnen Schichten entsprechende Stromdichten mit entsprechenden Stromdichteverteilungen aus. Abhängig von der Stromdichteverteilung im aktiven Bereich, insbesondere der Stromdichteverteilung entlang der Haupterstreckungsrichtung des aktiven Bereichs, wird die im aktiven Bereich erzeugte elektromagnetische Strahlung mit einer entsprechenden Leuchtdichteverteilung erzeugt und abgestrahlt.

Da das hier beschriebene organische strahlungsemittierende Bauelement die erste organische funktionelle Schicht mit den Teilbereichen mit dem ersten und zweiten Material mit der ersten beziehungsweise der zweiten elektrischen Leitfähigkeit aufweist, können in Abhängigkeit von den relativen Anteilen des ersten und zweiten Materials zueinander die elektrischen Leitfähigkeiten der Teilbereiche gezielt beeinflusst werden.

Im Vergleich dazu werden bei bekannten OLEDs üblicherweise Leiterbahnstrukturen auf einer oder beiden Elektroden angeordnet, die die Stromdichteverteilung in der oder den Elektroden homogenisieren sollen. Derartige Leiterbahnen, die als Metallisierungen hochleitfähiger Metalle ausgebildet werden und die auch als so genannte "bus bars" bezeichnet werden können, sind jedoch üblicherweise nicht transparent oder zumindest weniger transparent als beispielsweise eine transparente Elektrode, auf der sie angeordnet sind. Dadurch werden durch die "bus bars" unerwünschte dunkle Bereiche auf der OLED hervorgerufen, wodurch die Leuchtdichte und damit auch die Flächeneffizienz der OLED sinken. Daher muss bei bekannten OLEDs gleichzeitig mit der Erhöhung der Homogenität der Stromdichteverteilung eine Verringerung der Auskoppeleffizienz des in der OLED erzeugten Lichts in Kauf genommen werden.

Bei dem hier beschriebenen organischen strahlungsemittierenden Bauelement hingegen wurde überraschend festgestellt, dass eine Anpassung und weiterhin eine gewünschte Ausbildung der Stromdichteverteilung im aktiven Bereich durch die hier beschriebene erste organische funktionelle Schicht mit den Teilbereichen mit dem ersten und zweiten Material möglich ist. Dadurch können auch die partiellen Widerstände einzelner (gedachter) Strompfade durch die Schichten des organischen strahlungsemittierenden Bauelements gezielt angepasst werden, so dass dadurch wiederum auch die Leuchtdichteverteilung der im aktiven Bereich erzeugten elektromagnetischen Strahlung gezielt angepasst werden kann. Daher können im Vergleich zu bekannten organischen Bauelementen die Anzahl und/oder die Abmessungen von Leiterbahnstrukturen beziehungsweise von "bus bars" auf einer oder beiden Elektroden zumindest verringert werden und besonders vorteilhaft können diese Leiterbahnstrukturen gänzlich unnötig sein und im vorliegenden organischen strahlungsemittierenden Bauelement nicht vorhanden sein. Insbesondere kann es bei dem hier beschriebenen organischen strahlungsemittierenden Bauelement möglich sein, dass gerade nicht die Leitfähigkeit der ersten und/oder der zweiten Elektrode beeinflusst beziehungsweise angepasst werden muss, sondern ganz im Gegenteil der elektrische Widerstand beziehungsweise die elektrische Leitfähigkeit der ersten organischen Schicht durch die Ausbildung beziehungsweise Anordnung der oben genannten Mehrzahl von Teilbereichen mit dem ersten und dem zweiten Material.

Die erste organische funktionelle Schicht weist dabei eine der ersten Elektrode zugewandte erste Hauptoberfläche und einer dem aktiven Bereich zugewandte zweite Hauptoberfläche auf. Die Teilbereiche mit dem ersten und zweiten Material erstrecken sich bevorzugt von der ersten zur zweiten Hauptoberfläche der ersten organischen funktionellen Schicht und weisen damit eine Höhe auf, die gleich der Dicke der ersten organischen funktionellen Schicht ist. Die Teilbereiche können dabei direkt aneinander angrenzen, so dass die Mehrzahl der Teilbereiche die erste organische funktionelle Schicht bildet. Besonders bevorzugt weisen nebeneinander benachbart angeordnete Teilbereiche keine sichtbare Grenzfläche auf und gehen vielmehr ineinander über, so dass die erste organische funktionelle Schicht im organischen strahlungsemittierenden Bauelement als durchgehende Schicht ausgebildet sein kann. Die einzelnen Teilbereiche können dabei aufgrund des jeweiligen Anteils des ersten Materials und der zweiten Materials beziehungsweise durch das Verhältnis dieser Anteile zueinander voneinander unterscheidbar sein.

Insbesondere können die Teilbereiche in der ersten organischen funktionellen Schicht derart ausgebildet und angeordnet sein, dass das Verhältnis des Anteils des zweiten Materials zum Anteil des ersten Materials mit steigendem lateralem Abstand zum ersten elektrischen Kontaktbereich größer wird. Da das erste Material eine geringere elektrische Leitfähigkeit als das zweite Material aufweist, kann das insbesondere bedeuten, dass die elektrische Leitfähigkeit der Teilbereiche mit größer werdendem lateralem Abstand zum ersten elektrischen Kontaktbereich größer wird. Bei dem hier beschriebenen organischen strahlungsemittierenden Bauelement wurde überraschend festgestellt, dass gerade dadurch die partiellen Widerstände von (gedachten) verschiedenen Strompfaden zwischen dem ersten elektrischen Kontaktbereich und dem aktiven Bereich, die voneinander unterschiedlich lange Anteile der (gedachten) Strompfade vom ersten elektrischen Kontaktbereich durch die erste Elektrode in die erste organische funktionelle Schicht aufweisen, aneinander anzupassen.

Der erste elektrische Kontaktbereich kann in einer der oben genannten Ausführungen ausgebildet sein und eine punkt-, linien- oder flächenartige ausgebildete Kontaktfläche mit der ersten Elektrode aufweisen. Insbesondere eine linien- oder flächenartig ausgebildete Kontaktfläche kann sich dabei entlang oder auch teilweise auf einem Teil der ersten Elektrode erstrecken. Dabei kann der erste elektrische Kontaktbereich einen oder mehrere Bereiche aufweisen, die aneinanderhängen oder voneinander getrennt mit der ersten Elektrode in elektrischem Kontakt stehen. Ein "lateraler Abstand zum ersten Kontaktbereich" kann somit beispielsweise einen mittleren lateralen Abstand eines Teilbereichs der ersten organischen funktionalen Schicht bezeichnen, der über die lateralen Abstände aller elektrischen Kontaktpunkte zwischen dem ersten Kontaktbereich und der ersten Elektrode gemittelt ist. Dabei kann eine arithmetische, eine geometrische oder eine geeignete andere summierende oder integrierende Mittelungsmethode mit gedachten diskreten Kontaktpunkten endlicher Größe oder infinitesimal klein angenommenen Kontaktpunkten herangezogen werden. Insbesondere können das erste Material und das zweite Material hinsichtlich ihrer jeweiligen Anteile in den Teilbereichen der ersten organischen funktionellen Schicht eine Verteilungsfunktion beziehungsweise -dichte aufweisen, die von der Anordnung und Ausgestaltung des ersten Kontaktbereichs abhängt.

Jeder der Teilbereiche der ersten organischen funktionellen Schicht weist innerhalb des Teilbereichs eine gleichmäßige Verteilung des zweiten Materials im ersten Material auf. Das kann beispielsweise bedeuten, dass ein Teilbereich in eine Mehrzahl von gedachten gleichen Volumenelementen unterteilt werden kann und in jedem der Volumenelemente das Verhältnis des Anteils des zweiten Materials zum Anteil des ersten Materials gleich zum entsprechenden Verhältnis im gesamten Teilbereich ist. Die gedachten Volumenelemente können beispielsweise senkrecht zur Haupterstreckungsrichtung der ersten organischen funktionellen Schicht übereinander angeordnete Schichtbereiche beziehungsweise "Scheibchen" sein.

Hier und im Folgenden kann das Verhältnis des Anteils des zweiten Materials zum Anteil des ersten Materials als Verhältnis in Volumenanteilen, Gewichtsanteilen oder Molanteilen charakterisiert sein und auch als "Konzentration" des zweiten Materials im ersten Material bezeichnet sein.

Weiterhin weist jeder der Teilbereiche der ersten organischen funktionellen Schicht jeweils einen ersten Funktionsbereich mit dem ersten und dem zweiten Material und weiterhin einen zweiten Funktionsbereich mit dem ersten Material auf. Die Volumenkonzentration des zweiten Materials ist dabei im Verhältnis zum ersten Material in den ersten Funktionsbereichen verschiedener Teilbereiche gleich während jeweils der zweite Funktionsbereich der Teilbereiche frei vom zweiten Material ist. Je ein erster und ein zweiter Funktionsbereich können insbesondere einen Teilbereich bilden, so dass mit anderen Worten jeder der Teilbereiche aus genau einem ersten und einem zweiten Funktionsbereich besteht.

Insbesondere können alle ersten Funktionsbereiche der Teilbereiche an ein und dieselbe Hauptoberfläche, beispielsweise die der ersten Elektrode zugewandte Hauptoberfläche, der ersten organischen funktionellen Schicht angrenzen beziehungsweise diese bilden, während alle zweiten Funktionsbereiche der Teilbereiche an die andere Hauptoberfläche, beispielsweise die dem aktiven Bereich zugewandte Hauptoberfläche, der ersten organischen funktionellen Schicht angrenzen beziehungsweise diese bilden können.

Weiterhin können der erste Funktionsbereich eines Teilbereichs ein erstes Volumen und der zweite Funktionsbereich eines Teilbereichs ein zweites Volumen aufweisen. Das jeweilige Verhältnis des ersten Volumens zum zweiten Volumen kann mit steigendem lateralem Abstand zum ersten elektrischen Kontaktbereich größer werden. Mit anderen Worten kann das bedeuten, dass mit steigendem lateralem Abstand vom ersten Kontaktbereich die Dicke der ersten Funktionsbereiche zunimmt, während die Dicke der zweiten Funktionsbereiche abnimmt. Dadurch kann innerhalb der Teilbereiche mit steigendem lateralem Abstand vom ersten Kontaktbereich der Anteil des zweiten Materials im Verhältnis zum Anteil des ersten Materials ansteigen, wodurch eine Vergrößerung der elektrischen Leitfähigkeit der Teilbereiche mit steigendem lateralem Abstand zum ersten elektrischen Kontaktbereich mit den bereits vorab beschriebenen Effekten und Vorteilen erreicht werden kann.

Die ersten Funktionsbereiche der Teilbereiche der ersten organischen funktionellen Schicht können weiterhin auch eine erste Teilschicht der ersten organischen funktionellen Schicht bilden, während die zweiten Funktionsbereiche eine zweite Teilschicht bilden. Zwischen der ersten und zweiten Teilschicht kann eine stufig geformte oder eine kontinuierlich gekrümmte gedachte Grenzfläche ausgebildet sein.

Weiterhin kann das erste Material ein organisches elektrisch leitendes Matrixmaterial aufweisen, in das das zweite Material in Form eines Dotierstoffes eingebracht ist. Dabei ist bei dem hier beschriebenen organischen strahlungsemittierenden Bauelement die Bezeichnung "Dotierung" nicht einschränkend hinsichtlich der Konzentration des zweiten Materials im Verhältnis zum ersten Material zu verstehen. Insbesondere kann in einem Teilbereich der Anteil des zweiten Materials als "Dotierstoff" beispielsweise kleiner oder gleich oder auch größer als der Anteil des ersten Materials als "Matrixmaterial" sein.

Das erste Material und das zweite Material können zusammen so genannte Charge-Transfer-Komplexe bilden. Das kann bedeuten, das das erste Material und das zweite Material Elektronen-Donor-Akzeptor-Komplexe bilden, deren elektrischen und/oder optischen Eigenschaften verschieden von denen des ersten und zweiten Materials jeweils alleine sein können. Die Charge-Transfer-Komplexe können dabei insbesondere dazu beitragen, dass die elektrische Leitfähigkeit in einem Teilbereich mit dem ersten und dem zweiten Material größer als die elektrische Leitfähigkeit des ersten Materials alleine ist. Besonders bevorzugt weisen die durch das erste und zweite Material gebildeten Charge-Transfer-Komplexe Absorptionsbanden auf, die außerhalb des Wellenlängenbereichs der im aktiven Bereich erzeugten elektromagnetischen Strahlung liegen, so dass die Charge-Transfer-Komplexe bevorzugt zumindest teilweise transparent für die im aktiven Bereich erzeugte elektromagnetische Strahlung sind. Beispielsweise können die Charge-Transfer-Komplexe bei einem organischen strahlungsemittierenden Bauelement für Beleuchtungszwecke zumindest transparent für sichtbares Licht sein.

"Zumindest teilweise transparent" für eine Wellenlänge kann hier und im Folgenden insbesondere Transparenz von größer oder gleich 80% und bevorzugt von größer oder gleich 90% und entsprechend eine Absorption von kleiner oder gleich 20% und besonders bevorzugt von kleiner oder gleich 10% bei dieser Wellenlänge bedeuten. Der sichtbare Wellenlängenbereich wird dabei hier und im Folgenden mit einem Wellenlängenbereich zwischen etwa 400 und etwa 700 Nanometer angenommen.

Weiterhin kann zwischen der ersten organischen funktionellen Schicht und dem aktiven Bereich eine zweite organische funktionelle Schicht mit dem ersten Material angeordnet sein, die frei vom zweiten Material ist und die direkt an den aktiven Bereich angrenzt. Dadurch kann eine Trennung der Charge-Transfer-Komplexe in den Teilbereichen der ersten organischen funktionellen Schicht vom aktiven Bereich möglich sein, so dass verhindert werden kann, dass die Charge-Transfer-Komplexe der ersten organischen funktionellen Schicht die Erzeugung von elektromagnetischer Strahlung im aktiven Bereich unterdrücken (so genanntes "quenching").

Insbesondere kann die erste funktionelle Schicht als Ladungsträgertransportschicht ausgebildet sein, die geeignet ist, durch die erste Elektrode injizierte Ladungsträger in den aktiven Bereich zu transportieren. Dabei kann die erste funktionelle Schicht als Lochtransportschicht und/oder als Elektronentransportschicht ausgebildet sein.

Weiterhin kann auch die zweite Elektrode einen zweiten elektrischen Kontaktbereich zur elektrischen Kontaktierung der zweiten Elektrode aufweisen. Der zweite elektrische Kontaktbereich kann dabei eines oder mehrere der vorab in Verbindung mit dem ersten elektrischen Kontaktbereich beschriebenen Merkmale aufweisen. Zwischen dem aktiven Bereich und der zweiten Elektrode kann eine dritte organische funktionelle Schicht angeordnet sein, die eine Mehrzahl von lateral angeordneten Teilbereichen mit jeweils einem dritten Material mit einer dritten elektrischen Leitfähigkeit und einem vierten Material mit einer vierten elektrischen Leitfähigkeit aufweisen kann, wobei die vierte elektrische Leitfähigkeit größer als die dritte elektrische Leitfähigkeit ist und das Verhältnis des Anteils des vierten Materials zum Anteil des dritten Materials in den Teilbereichen der dritten organischen funktionellen Schicht in Abhängigkeit von einem lateralen Abstand zum ersten elektrischen Kontaktbereich und/oder in Abhängigkeit von einem lateralen Abstand zum zweiten elektrischen Kontaktbereich variiert.

Dabei kann die dritte organische funktionelle Schicht eines oder mehrere der vorab oder im Folgenden im Zusammenhang mit der ersten organischen funktionellen Schicht beschriebenen Merkmalen aufweisen. Weiterhin kann das dritte Material eines oder mehrere der vorab oder im Folgenden im Zusammenhang mit dem ersten Material beschriebenen Merkmalen aufweisen, während das vierte Material eines oder mehrere der vorab oder im Folgenden im Zusammenhang mit dem zweiten Material beschriebenen Merkmalen aufweisen kann.

Durch die derart ausgebildete dritte organische funktionelle Schicht in Verbindung mit der vorab beschriebenen ersten organischen funktionellen Schicht kann eine gezielte Anpassung der Stromdichteverteilung im aktiven Bereich beispielsweise bei großflächigen organischen strahlungsemittierenden Bauelementen weiter verbessert werden.

Zwischen dem aktiven Bereich und der dritten organischen funktionellen Schicht kann eine vierte organische funktionelle Schicht mit dem dritten Material angeordnet sein, die frei vom vierten Material ist und die direkt an den aktiven Bereich angrenzt. Dadurch kann, wie schon im Zusammenhang mit der zweiten organischen funktionellen Schicht weiter oben erläutert, ein "quenching" der Erzeugung der elektromagnetischen Strahlung im aktiven Bereich durch Charge-Transfer-Komplexe aus dem dritten und vierten Material verhindert werden.

Ist die erste organische funktionelle Schicht als Lochtransportschicht ausgebildet, so ist die dritte organische funktionelle Schicht bevorzugt als Elektronentransportschicht ausgebildet. Ist die erste organische funktionelle Schicht als Elektronentransportschicht ausgebildet, so ist die dritte organische funktionelle Schicht bevorzugt als Lochtransportschicht ausgebildet. Die in Folgenden beschriebenen Materialien und Merkmale für die erste organische funktionelle Schicht und das erste beziehungsweise das zweite Material gelten entsprechend auch für die dritte organische funktionelle Schicht und das dritte beziehungsweise das vierte Material, soweit nichts anderes vermerkt ist.

Das erste Material kann je nach Ausführung der ersten organischen funktionellen Schicht als Lochtransportschicht oder als Elektronentransportschicht aus einer Gruppe ausgewählt sein, die Phenanthrolinderivate, Imidazolderivate, Triazolderivate, Oxadiazolderivate, Phenyl-haltige Verbindungen, Verbindungen mit kondensierten Aromaten, Carbazol-haltige Verbindungen, Fluorenderivate, Spirofluorenderivate und Pyridin-haltige Verbindungen sowie Kombinationen aus zumindest zwei oder mehreren der genannten Materialien umfasst.

Für eine als Lochtransportschicht ausgebildete erste organische funktionelle Schicht eignen sich insbesondere eines oder mehrere der folgenden Materialien als erstes Material:

N,N'-Bis(naphthalen-1-yl)-N,N'-bis(phenyl)-benzidin (NPB),
N,N'-Bis(naphthalen-2-yl)-N,N'-bis(phenyl)-benzidin (β-NPB),
N,N'-Bis(3-methylphenyl)-1,1'-bis(phenyl)-4,4'-diamin (TPD),
N,N'-Bis(3-methylphenyl)-N,N'-bis(phenyl)-9,9-spirobifluoren (Spiro-TPD),
N,N'-Bis(naphthalen-1-yl)-N,N'-bis(phenyl)-9,9-spirobifluoren (Spiro-NPB),
4,4',4"-Tris(N-(naphth-1-yl)-N-phenyl-amino)-triphenylamin (1-TNATA),
2,2',7,7'-Tetrakis-(N,n'-di-p-methylphenylamino)-9,9'-spirobifluoren (Spiro-TTB),
N,N'-Bis(3-methylphenyl)-N,N'-bis(phenyl)-9,9-dimethylfluoren (DMFL-TPD),
N,N'-Bis(naphthalen-1-yl)-N,N'-bis(phenyl)-9,9-dimethylfluoren (DMFL-NPB),
N,N'-Bis-(3-methylphenyl)-N,N'-bis(phenyl)-9,9-diphenylfluoren (DPFL-TPD),

N,N'-Bis(naphthalen-1-yl)-N,N'-bis(phenyl)-9,9-diphenylfluoren (DPFL-NPB),

2,2',7,7'-Tetrakis(N,N-diphenylamino)-9,9'-spirobifluoren (Spiro-TAD),

9,9-Bis[4-(N,N-bis-biphenyl-4-yl-amino)phenyl]-9H-fluoren (BPAPF),

9,9-Bis (4-(N,N-bis-naphthalen-2-yl-amino)phenyl)-9H-fluoren (NPAPF),

9,9-Bis[4-(N,N'-bis-naphthalen-2-yl-N,N'-bis-phenyl-amino)-phenyl]-9H-fluoren (NPBAPF),

2,2',7,7'-Tetrakis [N-naphthalenyl(phenyl)-amino]-9,9-spirobifluoren (Spiro-2NPB),

N,N'-Bis(phenanthren-9-yl)-N,N'-bis(phenyl)-benzidin (PAPB),

2,7-Bis[N,N-bis(9,9-spiro-bifluorene-2-yl)-amino]-9,9-spirobifluoren (Spiro-S),

2,2'-Bis[N,N-bis(biphenyl-4-vl)amino] -9,9-spirobifluoren (2,2'-Spiro-DBP),

2,2'-Bis(N,N-di-phenyl-amino)-9,9-spirobifluoren (Spiro-BPA).

Für eine als Elektronentransportschicht ausgebildete erste organische funktionelle Schicht eignen sich insbesondere eines oder mehrere der folgenden Materialien als erstes Material:

8-Hydroxyquinolinolato-lithium (Liq),

2,2',2"-(1,3,5-Benzinetriyl)-tris(1-phenyl-1-H-benzimidazol) (TPBi),

2-((4-Biphenylyl)-5-(4-tert-butylphenyl)-1,3,4-oxadiazol (PBD),

2,9-Dimethyl-4,7-diphenyl-1,10-phenanthrolin (BCP),

4,7-Diphenyl-1,10-phenanthrolin (BPhen),

Bis-(2-methyl-8-quinolinolat)-4-(phenylphenolato)aluminium (BAlq),

1,3-Bis[2-(2,2'-bipyridin-6-yl)-1,3,4-oxadiazo-5-yl]benzen (Bpy-OXD),

6,6'-Bis[5-(biphenyl-4-yl)-1,3,4-oxadiazo-2-yl]-2,2'-bipyridyl (BP-OXD-Bpy),

3-((4-Biphenylyl)-4-phenyl-5-tert-butylphenyl-1,2,4-triazol (TAZ),

4-((Naphthalen-1-yl)-3,5-diphenyl-4H-1,2,4-triazol (NTAZ),

2,9-Bis(naphthalen-2-yl)-4,7-diphenyl-1,10-phenanthrolin (NBphen),

2,7,-Bis[2-(2,2'-bipyridin-6-yl)-1,3,4-oxadiazo-5-yl]-9,9-dimethylfluoren (Bby-FOXD),

1,3-Bis[2-(4-tert-butylphenyl)-1,3,4-oxadiazo-5-yl]benzen (OXD-7).

Beispielsweise kann die erste organische funktionelle Schicht als Lochtransportschicht ausgeführt sein. Das kann bedeuten, dass das zweite Material eine p-Dotierung des ersten Materials ermöglicht und das zweite Material als Elektronenpaarakzeptormaterial ausgebildet ist.

Das zweite Material kann dabei ein Metalloxid, eine metallorganische Verbindung, ein organisches Material oder eine Mischung daraus aufweisen oder sein. Das zweite Material kann zusätzlich oder alternativ eine Mehrzahl verschiedener Metalloxide und/oder eine Mehrzahl verschiedener metallorganischer Verbindungen und/oder einer Mehrzahl verschiedener organischer Verbindungen aufweisen. Insbesondere kann das zweite Material Lewis-Säure-Charakter haben oder eine Lewis-Säure sein. Lewis-Säuren, das heißt Elektronenpaarakzeptoren, können besonders geeignet zur Bildung von Charge-Transfer-Komplexen sein.

Das zweite Material kann eines oder mehrere Metalloxide mit einem oder mehreren Metallen aufweisen, wobei die Metalle ausgewählt sind aus Wolfram, Molybdän, Vanadium und Rhenium. Besonders bevorzugt kann der Dotierstoff eines oder mehrere der Metalloxide $WO_3$, $MoO_3$, $V_2O_5$, $Re_2O_7$ und $Re_2O_5$ aufweisen.

Weiterhin kann das zweite Material auch metallorganische Verbindungen mit Lewis-Säure-Charakter aufweisen. Insbesondere bei metallorganischen Verbindungen beziehungsweise Komplexen mit Schaufelradstruktur ist der Lewis-Säure-Charakter der axialen Position besonders ausgeprägt.

Ferner können die metallorganischen Verbindungen Ruthenium und/oder Rhodium aufweisen. Beispielsweise kann das zweite Material als metallorganische Verbindung ein Trifluoroacetat (TFA) aufweisen, beispielsweise Di-rhodium-tetratrifluoroacetat ($Rh_2(TFA)_4$), die isoelektronische Rutheniumverbindung $Ru_2(TFA)_2(CO)_2$ und/oder 2,3,5,6-Tetrafluoro-7,7,8,8-tetracyanoquinodimethan ($F_4$TCNQ).

Weiterhin kann das zweite Material organische Materialien aufweisen, die aromatische funktionelle Gruppen aufweisen oder aromatische organische Materialien sind. Insbesondere kann das zweite Material aromatische Materialien mit einer ausgeprägten Anzahl von Fluor- und/oder Cyanid(CN)-Substituenten aufweisen.

Weiterhin kann die erste organische funktionelle Schicht als Elektronentransportschicht ausgeführt sein. Das kann bedeuten, dass das zweite Material eine n-Dotierung des ersten Materials ermöglicht. Das zweite Material kann dabei ein Alkalimetallsalz, ein Erdalkalimetallsalz, ein metallorganische Verbindung oder eine Mischung daraus aufweisen oder sein. Das zweite Material kann zusätzlich oder alternativ eine Mehrzahl verschiedener Alkalimetallsalze und/oder eine Mehrzahl verschiedener Erdalkalimetallsalze und/oder einer Mehrzahl verschiedener metallorganischer Verbindungen aufweisen. Weiterhin kann das zweite Material auch ein Carbonat aufweisen. Weiterhin kann das zweite Material besonders bevorzugt Cäsium oder Calcium aufweisen.

Weiterhin kann das zweite Material ein Metallocen aufweisen, also eine metallorganische Verbindung mit einem Metall M und zwei Cyclopentadienylresten (Cp) in der Form $M(Cp)_2$, beispielsweise Chromocen und Decamethylchromocen. Alternativ oder zusätzlich kann das zweite Material auch einen Metall-Hydropyrimidopyrimidin-Komplex aufweisen. Das Metall kann beispielsweise Wolfram, Molybdän und/oder Chrom umfassen oder sein. Das zweite Material kann beispielsweise metallorganische Verbindungen mit 1,2,4,6,7,8-Hexahydro-2H-pyrimido[1,2-a]pyrimidin (hpp) wie etwa $W_2(hpp)_4$, $Mo_2(hpp)_4$ und $Cr_2(hpp)_4$ aufweisen.

Die vorab genannten zweiten Materialien können jeweils die Eigenschaft aufweisen, in einem der vorab genannten ersten Materialien freie Ladungsträger zu erzeugen und somit die elektrische Leitfähigkeit zu erhöhen. In diesem Sinne kann in der vorliegenden Anmeldung auch das Merkmal verstanden werden, dass die zweite elektrische Leitfähigkeit höher als die elektrische Leitfähigkeit ist.

Das organische strahlungsemittierende Bauelement kann weiterhin ein Substrat aufweisen. Die erste Elektrode kann dabei transparent sein und auf dem Substrat und zwischen dem Substrat und der ersten organischen funktionellen Schicht angeordnet sein. Dabei kann das Substrat ebenfalls transparent sein. Somit kann die im aktiven Bereich erzeugte elektromagnetische Strahlung in diesem Fall durch das Substrat und die erste Elektrode abgestrahlt werden und das organische strahlungsemittierende Bauelement ist als so genannter "Bottom-Emitter" ausgeführt.

Weiterhin kann die erste Elektrode auch transparent sein und vom Substrat aus gesehen über dem aktiven Bereich angeordnet sein. Dabei kann die im aktiven Bereich erzeugte elektromagnetische Strahlung im diesem Fall in eine vom Substrat weggewandte Abstrahlrichtung abgestrahlt werden und das organische strahlungsemittierende Bauelement ist als so genannter "Top-Emitter" ausgeführt.

Ist auch die zweite Elektrode transparent ausgeführt, kann das organische strahlungsemittierende Bauelement auch beidseitig emittierend ausgeführt sein.

Beispielsweise kann das Substrat Glas, Quarz, Kunststofffolien, Metall, Metallfolien, Siliziumwafer oder ein anderes geeignetes Substratmaterial umfassen.

Die erste Elektrode kann beispielsweise als Anode ausgeführt sein und somit als löcherinjizierendes Material dienen. Dabei kann die erste Elektrode beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, $SnO_2$ oder $In_2O_3$ gehören auch ternäre Metallsauerstoffverbindungen, wie beispielsweise $Zn_2SnO_4$, $CdSnO_3$, $ZnSnO_3$, $MgIn_2O_4$, $GaInO_3$, $Zn_2In_2O_5$ oder $In_4Sn_3O_{12}$ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Weiterhin kann eine als Anode ausgeführte erste Elektrode ein elektrisch leitendes Polymer wie etwa polystyrolsulfondotiertes Polydiethoxythiophen (PEDOT:PSS) und/oder champhersulfonsäuredotiertes Polyanilin (PANI) aufweisen oder daraus sein.

Die organische Schichtenfolge kann neben den oben für die erste und gegebenenfalls für die zweite, dritte und/oder vierte organische funktionelle Schicht genannten Materialien weitere Schichten mit organischen Polymeren, organischen Oligomeren, organischen Monomeren, organischen kleinen, nicht-polymeren Molekülen ("small molecules") oder Kombinationen daraus aufweisen. Dabei kann die organische Schichtenfolge zusätzlich zur ersten und gegebenenfalls zur zweiten, dritten und/oder vierten organischen funktionellen Schicht weitere funktionelle Schichten wie etwa weitere Ladungsträgertransportschichten, Ladungsträgerinjektionsschichten, Ladungsträgerblockierschichten und als aktiven Bereich elektrolumineszierende Schichten aufweisen. Eine elektrolumineszierende Schicht kann dabei geeignet sein, durch Rekombination von Elektronen und Löchern elektromagnetischer Strahlung zu erzeugen. Abhängig von den Materialien in den funktionellen Schichten und insbesondere im aktiven Bereich der organischen Schichtenfolge kann die erzeugte elektromagnetische Strahlung einzelne Wellenlängen oder Bereiche oder Kombinationen daraus aus einem ultravioletten bis infraroten Wellenlängenbereich und besonders bevorzugt aus einem sichtbaren Wellenlängenbereich aufweisen.

Die zweite Elektrode kann als Kathode ausgeführt sein und somit als elektroneninjizierendes Material dienen. Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen. Zusätzlich kann die zweite Elektrode auf einer den organischen funktionellen Schichten zugewandten Seite eine Schicht umfassend LiF aufweisen, das gute Elektroneninjektionseigenschaften aufweist. Alternativ oder zusätzlich kann die zweite Elektrode auch eines der oben genannten TCOs oder eine Schichtenfolge aus TCO-Schichten und einer Metallschicht aufweisen. Die zweite Elektrode kann ebenfalls transparent sein.

Alternativ können die erste Elektrode auch als Kathode und die zweite Elektrode als Anode ausgeführt sein.

Die erste und/oder die zweite Elektrode können jeweils großflächig ausgebildet sein. Dadurch kann eine großflächige Abstrahlung der im aktiven Bereich erzeugten elektromagnetischen Strahlung ermöglicht werden. "Großflächig" kann dabei für das hier beschriebene organische strahlungsemittierende Bauelement bedeuten, dass das organische strahlungsemittierende Bauelement eine Fläche von größer oder gleich einigen Quadratmillimetern, bevorzugt größer oder gleich einem Quadratzentimeter und besonders bevorzugt größer oder gleich einem Quadratdezimeter aufweist. Alternativ oder zusätzlich können die erste und/oder die zweite Elektrode zumindest in Teilbereichen strukturiert ausgebildet sein. Dadurch kann eine strukturierte Abstrahlung der im aktiven Bereich erzeugten elektromagnetischen Strahlung ermöglicht werden, etwa in Form von Pixeln oder Piktogrammen.

Das organische strahlungsemittierende Bauelement kann eine Verkapselung in Form eines Glasdeckels und/oder einer Mehrschicht-Dünnfilm-Verkapselung aufweisen, um beispielsweise für die erste und zweite Elektrode und die organischen funktionellen Schichten einen Schutz vor Feuchtigkeit und/oder oxidierenden Substanzen wie etwa Sauerstoff zu erreichen.

Durch die Verwendung eines lateral variierendes Verhältnis des Anteils des zweiten Material zum Anteil des ersten Materials bei dem hier beschriebenen organischen strahlungsemittierenden Bauelement kann es möglich sein, großflächige Beleuchtungselemente mit homogener Lichtverteilung über die gesamte Fläche zu erzielen, ohne die Transparenz ein transparent ausgeführten ersten und/oder zweiten Elektrode zu verschlechtern. Im Gegensatz zu bekannten OLEDs kann die Anzahl der zusätzlichen Hilfsmetallisierungen reduziert werden oder es sogar gänzlich auf diese verzichtet werden. Zudem kann weiterhin das einstellen von beliebigen Helligkeitsprofilen möglich sein.

Gemäß einer weiteren Ausführungsform umfasst ein Verfahren zur Herstellung eines organischen strahlungsemittierenden Bauelements nach Anspruch 1 insbesondere die Schritte:

A) Bereitstellen der ersten Elektrode mit dem ersten elektrischen Kontaktbereich,
B) Aufbringen der ersten organischen funktionellen Schicht umfassend die Mehrzahl der lateral angeordneten Teilbereiche mit dem ersten und zweiten Material,
C) Aufbringen des aktiven Bereichs auf der ersten organischen funktionellen Schicht, und
D) Aufbringen der zweiten Elektrode auf dem aktiven Bereich.

Insbesondere kann das Verfahren geeignet sein, ein organisches strahlungsemittierendes Bauelement mit einem oder mehreren der vorab beschriebenen Merkmale herzustellen. Alle vorab in Verbindung mit dem organischen strahlungsemittierenden Bauelement genannten Merkmale und Vorteile beziehen sich entsprechend auch auf das hier beschriebene Verfahren.

Insbesondere können im Verfahrensschritt B das erste und zweite Material derart aufgebracht werden, dass das Verhältnis des zweiten Anteils zum ersten Anteil mit steigendem Abstand zum ersten elektrischen Kontaktbereich größer wird. Dadurch kann, wie oben beschrieben, die elektrische Leitfähigkeit der ersten organischen funktionellen Schicht in Abhängigkeit vom lateralen Abstand zum ersten Kontaktbereich gezielt vergrößert werden. Beispielsweise können das erste Material und das zweite Material je nach Materialform, also Polymeren, Oligomeren, Monomeren und/oder kleinen Molekülen, mittels Aufdampfen, Drucken, insbesondere Siebdruck, Aufschleudern oder mittels eines anderen geeigneten Aufbringverfahren auf der ersten Elektrode aufgebracht werden. Das erste Material kann beispielsweise großflächig aufgebracht werden, während das zweite Material weiterhin beispielsweise mittels einer verstellbaren Blende aufgebracht werden kann. Je nach gewünschter Ausbildung der Teilbereiche kann die verstellbare Blende beispielsweise eine Lochblende oder eine Schlitzblende sein.

In einem weiteren Verfahrensschritt nach dem Verfahrensschritt B und vor dem Verfahrensschritt C kann eine wie oben beschriebene zweite organische funktionelle Schicht aufgebracht werden.

Weiterhin können nach dem Verfahrensschritt C und vor dem Verfahrensschritt D eine wie oben beschriebene dritte und/oder eine wie oben beschriebene vierte organische funktionelle Schicht mittels einem der vorab genannten Verfahren aufgebracht auf dem aktiven Bereich werden.

Weitere Vorteile und vorteilhafte Ausführungsformen und Weiterbildungen der Erfindung ergeben sich aus den im Folgenden in Verbindung mit den Figuren 1 bis 9 beschriebenen Ausführungsformen.

Es zeigen:

Figur 1            ein Ersatzschaltbild eines organischen strahlungsemittierenden Bauelements,
Figur 2            eine schematische Darstellung eines Verfahrens zur Herstellung eines organischen strahlungsemittierenden Bauelements,
Figuren 3 bis 6    schematische Darstellungen von organischen strahlungsemittierenden Bauelementen und
Figuren 7 bis 9    Graphen mit Messungen elektrischer und optischer Eigenschaften von organischen funktionellen Schichten.

In den Ausführungsbeispielen und Figuren können gleiche oder gleich wirkende Bestandteile jeweils mit den gleichen Bezugzeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

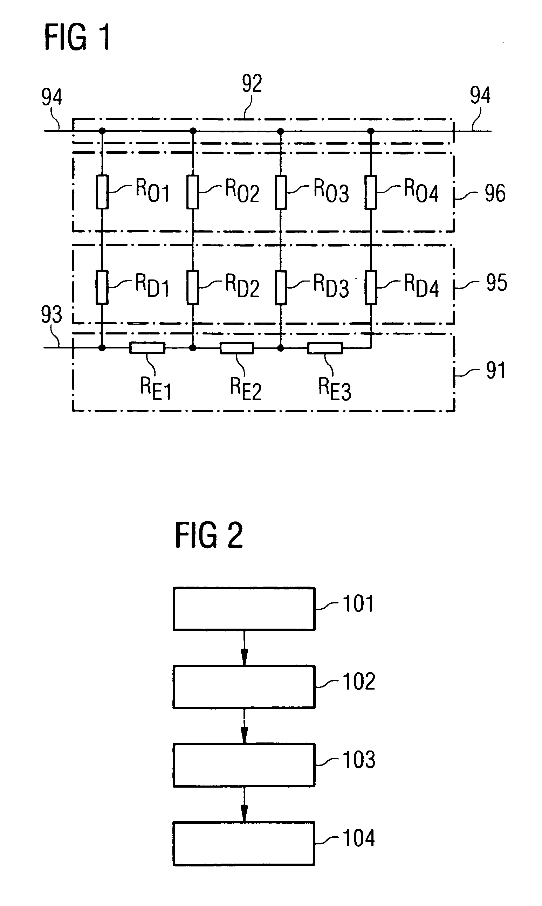

In Figur 1 ist ein Ersatzschaltbild eines organischen strahlungsemittierenden Bauelements gezeigt, das als organische Leuchtdiode (OLED) ausgeführt ist. Die gestrichelt angedeuteten Elemente kennzeichnen dabei verschiedene funktionelle Elemente und Bauteile der OLED in einer rein beispielhaft gezeigten Ausführung.

Das mit 91 gekennzeichnete Element steht für eine transparente Elektrode, die über einen elektrischen Anschluss 93 an eine externe Spannungs- und Stromversorgung (nicht gezeigt) angeschlossen ist. Das mit 92 gekennzeichnete Element steht für eine reflektierende Elektrode, die über elektrische Anschlüsse 94 an die externe Spannungs- und Stromversorgung angeschlossen ist. Zwischen den Elektroden 91, 92 sind rein beispielhaft eine einzelne organische Schicht 95 *sowie* weitere organische Schichten 96 angeordnet. Weiterhin sind vier gedachte Strompfade zwischen den elektrischen Anschlüssen 93 und 94 angedeutet, die auf vereinfachende Weise den durch die externe Spannungs- und Stromversorgung bedingten Stromfluss zwischen den elektrischen Anschlüssen 93 und 94 darstellen.

Entlang der gedachten Strompfade sind die einzelnen partiellen elektrischen Widerstände der jeweiligen Elemente eingezeichnet. Dabei kennzeichnen die partiellen Widerstände $R_{E1}$, $R_{E2}$ und $R_{E3}$ in der Summe den Gesamtwiderstand der transparenten Elektrode entlang einer Haupterstreckungsrichtung, der, wie im allgemeinen Teil beschrieben, durch das Material und die geringe Dicke der transparenten Elektrode hervorgerufen wird. Zwischen den gedachten Strompfaden werden der Einfachheit halber jeweils gleiche partielle Widerstände angenommen, also

$$R_{E1} = R_{E2} = R_{E3}.$$

Im Gegensatz dazu wird vereinfachend die Elektrode 92 mit einem vernachlässigbar kleinen elektrischen Widerstand angenommen, weswegen zwischen den Strompfaden im Element 92 keine partiellen Widerstände eingezeichnet sind.

Entlang der gedachten Strompfade weist die einzelne organische Schicht 95 die parallel zueinander angeordneten partiellen Widerstände $R_{D1}$, $R_{D2}$, $R_{D3}$ und $R_{D4}$ auf. Die weiteren organischen Schichten 96 weisen parallel zueinander angeordnete partielle Widerstände $R_{O1}$, $R_{O2}$, $R_{O3}$ und $R_{O4}$ auf, wobei angenommen wird, dass die weiteren organischen Schichten 96 hinsichtlich ihrer elektrischen Eigenschaften homogen sind, so dass gilt:

$$R_{O1} = R_{O2} = R_{O3} = R_{O4}.$$

Die gesamten partiellen Widerstände entlang der gedachten Strompfade zwischen den elektrischen Anschlüssen 93 und 94 ergeben sich somit aus den Summen über die jeweiligen partiellen Widerstände zu

$$R_1 = R_{D1} + R_{O1},$$

$$R_2 = R_{E1} + R_{D2} + R_{O2},$$

$$R_3 = R_{E1} + R_{E2} + R_{D3} + R_{O3}$$

und

$$R_4 = R_{E1} + R_{E2} + R_{E3} + R_{D4} + R_{O4}.$$

Bei herkömmlichen OLEDs sind alle organischen Schichten üblicherweise homogen hinsichtlich ihrer elektrischen Eigenschaften ausgebildet, so dass bei herkömmlichen OLEDs gilt:

$$R_{D1} = R_{D2} = R_{D3} = R_{D4}.$$

Daraus folgt aber unmittelbar, dass

$$R_1 < R_2 < R_3 < R_4,$$

was mit anderen Worten bedeutet, dass jeder der gedachten Strompfade einen von den anderen gedachten Strompfaden verschiedenen partiellen elektrischen Widerstand aufweist. Wie im allgemeinen Teil erläutert führt dies zu einer inhomogenen Stromdichteverteilung in den organischen Schichten und hierbei insbesondere auch in den elektrolumineszierenden Schichten, so dass eine derartig aufgebaute bekannte OLED eine inhomogene Intensitätsverteilung des abgestrahlten Lichts über die Abstrahlfläche der OLED aufweist. In einer OLED gemäß dem gezeigten Ersatzschaltbild würde die Intensität des abgestrahlten Lichts von links nach rechts mit steigendem Abstand zum elektrischen Anschluss 93 absinken, was zum so genannten "Badewanneneffekt" führt.

Im Gegensatz dazu weisen die organischen strahlungsemittierenden Bauelemente gemäß den Ausführungsformen im allgemeinen Teil und den folgenden Ausführungsbeispielen gezielt angepasste partielle Widerstände

$$R_{D1} > R_{D2} > R_{D3} > R_{D4}$$

auf, so dass für die organischen strahlungsemittierenden Bauelemente gemäß den folgenden Ausführungsbeispielen gilt:

$$R_1 = R_2 = R_3 = R_4.$$

Daraus ergibt sich bei den hier beschriebenen organischen strahlungsemittierenden Bauelementen eine homogene Stromdichteverteilung im aktiven Bereich, was zu einer homogenen Abstrahlintensität der erzeugten elektromagnetischen Strahlung führen kann.

In Figur 2 und in Verbindung mit den folgenden Figuren werden einige Verfahren zur Herstellung organischer strahlungsemittierender Bauelemente gemäß verschiedenen Ausführungsbeispielen beschrieben.

Dazu werden bei den im Folgenden beschriebenen Verfahren gemäß dem Verfahren in Figur 2 jeweils in einem mit dem Bezugszeichen gekennzeichneten ersten Verfahrensschritt A eine erste Elektrode mit einem ersten elektrischen Kontaktbereich bereitgestellt.

In einem weiteren mit dem Bezugszeichen 102 gekennzeichneten Verfahrensschritt B erfolgt ein Aufbringen einer ersten organischen funktionellen Schicht umfassend eine Mehrzahl von lateral angeordneten Teilbereichen mit einem ersten Material mit einer ersten elektrischen Leitfähigkeit und einem zweiten Material und einer zweiten elektrischen Leitfähigkeit. Dabei variiert das Verhältnis des Anteils des zweiten Materials zum Anteil des ersten Materials in den Teilbereichen der ersten organischen funktionellen Schicht in Abhängigkeit von einem lateralen Abstand zum ersten elektrischen Kontaktbereich. Weiterhin ist die zweite elektrische Leitfähigkeit größer als die erste elektrische Leitfähigkeit.

In einem weiteren mit dem Bezugszeichen 103 gekennzeichneten Verfahrensschritt C wird ein organischer aktiver Bereich auf der ersten organischen funktionellen Schicht aufgebracht.

In einem weiteren mit dem Bezugszeichen 104 gekennzeichneten Verfahrensschritt D wird auf dem aktiven Bereich eine zweite Elektrode aufgebracht.

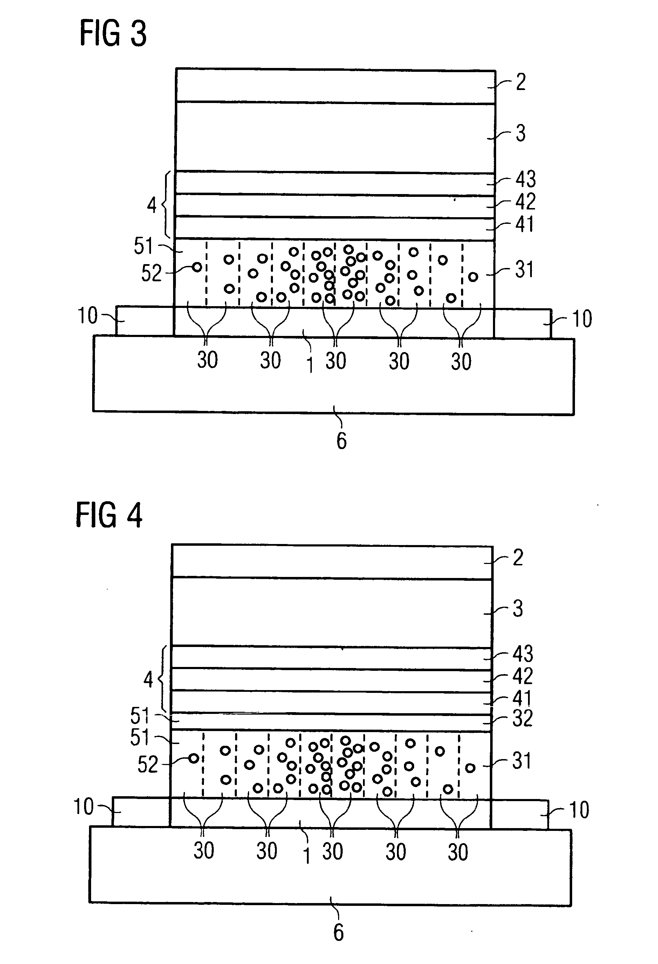

In Figur 3 ist ein Beispiel eines organischen strahlungsemittierenden Bauelements gezeigt, das eine erste Elektrode 1 auf einem Substrat 6 aufweist. Die erste Elektrode 1 weist einen ersten elektrischen Kontaktbereich 10 auf, der der elektrischen Kontaktierung und dem elektrischen Anschluss der ersten Elektrode 1 an eine externe Spannungs- und Stromversorgung (nicht gezeigt) dient. Hier und in den folgenden Ausführungsbeispielen ist der erste elektrische Kontaktbereich 10 rein beispielhaft in Form von symmetrisch um die erste Elektrode 1 angeordneten Kontaktpads aus Metall ausgebildet. Alternativ dazu sind andere Anordnungen des ersten elektrischen Kontaktbereichs in Form von punkt-, linien- oder flächenartigen Kontakten in symmetrischen oder asymmetrischen Anordnungen möglich.

Die erste Elektrode 1 weist im gezeigten Ausführungsbeispiel Indium-Zinn-Oxid (ITO) auf und ist transparent und als Anode ausgeführt. Das Substrat 6 ist ebenfalls transparent ausgeführt und ist aus Glas, so dass im weiter unten beschriebenen aktiven Bereich 4 erzeugte elektromagnetische Strahlung von dem als "Bottom-Emitter" ausgeführten organischen strahlungsemittierenden Bauelement durch die erste Elektrode 1 und das Substrat 6 abgestrahlt werden kann.

Auf der ersten Elektrode 1 ist eine erste organische funktionelle Schicht 31 aufgebracht. Auf der ersten organischen funktionellen Schicht 31 sind weiterhin ein aktiver Bereich 4 und eine weitere organische funktionelle Schicht 3 aufgebracht. Auf der weiteren organischen funktionellen Schicht 3 ist eine zweite Elektrode 2 aufgebracht, die als reflektierende Kathode ausgeführt ist und Aluminium aufweist.

Über der zweiten Elektrode 2 ist eine Verkapselung zum Schutz der Elektroden 1, 2 und der dazwischen liegenden Schichten 31, 4, 3 vor Feuchtigkeit und Sauerstoff aufgebracht, die der Übersichtlichkeit halber nicht gezeigt ist.

Der aktive Bereich 4 weist drei elektrolumineszierende Schichten 41, 42, 43 auf, die geeignet sind, voneinander verschiedenfarbige elektromagnetische Strahlung abzustrahlen. Beispielsweise kann die elektrolumineszierende Schicht 41 blaues Licht, die elektrolumineszierende Schicht 42 grünes Licht und die elektrolumineszierende Schicht 43 rotes Licht abstrahlen, so dass das gezeigte organische strahlungsemittierende Bauelement im Betrieb weißfarbiges Mischlicht als Überlagerung daraus abstrahlen kann.

Die weitere organische funktionelle Schicht 3 ist als Elektronentransportschicht ausgeführt, die geeignet ist, von der zweiten Elektrode 2 injizierte Elektronen in den aktiven Bereich zu transportieren.

Um einen homogenen Leuchteindruck über die gesamte Abstrahlfläche, die durch die dem aktiven Bereich 4 abgewandte Hauptoberfläche des Substrats 6 gegeben ist, zu ermöglichen, ist es erforderlich, dass die Stromdichteverteilung in den elektrolumineszierenden Schichten 41, 42 und 43 des aktiven Bereichs 4 homogen ist und keinen oben beschriebenen "Badewanneneffekt" bewirkt.

Dazu weist das organische strahlungsemittierende Bauelement die erste organische funktionelle Schicht 31 mit einer Mehrzahl von Teilbereichen 30 auf. Die Teilbereiche 30, die durch die gestrichelten Linien angedeutet sind, erstrecken sich dabei von der an die erste Elektrode 1 grenzenden Hauptoberfläche der ersten organischen funktionellen Schicht 31 bis zur an den aktiven Bereich grenzenden Hauptoberfläche und sind lateral entlang der Haupterstreckungsebene der ersten organischen funktionellen Schicht 31 angeordnet. Dabei sind die Teilbereiche 30 wie im allgemeinen Teil beschrieben ineinander übergehend und ohne Grenzflächen ausgebildet, so dass die erste organische funktionelle Schicht 31 durchgehend ausgebildet ist. Die Abmessungen der Teilbereiche 30 in Figur 3 sowie in den folgenden Figuren sind der Übersichtlichkeit halber übertrieben groß dargestellt.

Die erste funktionelle Schicht 31 ist als Lochtransportschicht ausgeführt und weist ein erstes Material 51 mit einer ersten elektrischen Leitfähigkeit und ein zweites Material 52 mit einer zweiten elektrischen Leitfähigkeit auf, wobei die zweite elektrische Leitfähigkeit größer als die erste elektrische Leitfähigkeit ist. Dabei variiert das Verhältnis des Anteils des zweiten Materials 52 zum Anteil des ersten Materials 51 in den Teilbereichen 30 in Abhängigkeit von einem lateralen Abstand zum ersten elektrischen Kontaktbereich 10.

Im gezeigten Beispiel sind das erste Material 51 N,N'-Bis(naphthalen-1-yl)-N,N'-bis(phenyl)-benzidin (NPB) und das zweite Material Rheniumheptoxid ($Re_2O_7$). Alternativ oder zusätzlich dazu können das erste und/oder das zweite Material 51, 52 eines oder mehrere der weiteren im allgemeinen Teil aufgeführten Materialien aufweisen. Da das erste und das zweite Material 51, 52 Charge-Transfer-Komplexe bilden, ist die Auswahl und Kombination möglicher erste und zweiter Materialien 51, 52 auf solche beschränkt, die keine oder nur eine geringe Absorption, also etwa keinen Charge-Transfer-Peak, im sichtbaren Wellenlängenbereich aufweisen, da ansonsten aufgrund der Variation des Verhältnisses des Anteils des zweiten Materials 52 zum Anteil des ersten Materials 51 in den Teilbereichen 30 keine gleichmäßige Transparenz der ersten organischen funktionellen Schicht gewährleistet wäre.

Die erste organische funktionelle Schicht 31 ist dabei derart ausgebildet, dass das Verhältnis des Anteils des zweiten Materials 52 zum Anteil des ersten Materials 51 mit steigendem lateralen Abstand zum ersten elektrischen Kontaktbereich 10 größer wird. Aufgrund der Anordnung des ersten elektrischen Kontaktbereichs 10 bedeutet dies, dass in den Teilbereichen 30 im Randbereich des organischen strahlungsemittierenden Bauelements der Anteil des zweiten Materials 52 im Verhältnis zum Anteil des ersten Materials 51 niedriger ist und zur Mitte des organischen strahlungsemittierenden Bauelements hin ansteigt. Dabei weist jeder der Teilbereiche 30 der ersten organischen funktionellen Schicht 31 innerhalb des Teilbereichs 30 eine gleichmäßige Verteilung des zweiten Materials im ersten Material auf.

Durch die derart ausgeführten Teilbereiche 30 ist es möglich, den elektrischen Widerstand der ersten organischen funktionellen Schicht 31 zur Mitte hin, also mit steigendem lateralem Abstand zum ersten elektrischen Kontaktbereich 10, zu verringern. Dadurch wird der in Verbindung mit Figur 1 erläuterte Effekt erreicht, nämlich dass die jeweiligen partiellen Widerstände von gedachten Strompfaden zwischen dem ersten Kontaktbereich 10 und der zweiten Elektrode 2 gleich groß oder zumindest in etwa gleich groß sind, wodurch eine homogene Abstrahlung der im aktiven Bereich erzeugten elektromagnetische Strahlung ermöglicht wird. "In etwa gleich groß" bedeutet dabei eine Variation von weniger als 20% und besonders bevorzugt von weniger als 10%.

Da die erste organische funktionelle Schicht 31 eine gleichmäßige Dicke aufweist, kann weiterhin sichergestellt werden, dass keine Farbverschiebungen durch unterschiedliche Kavitätseffekte in verschiedenen Teilbereichen 30 auftreten.

Zur Herstellung des in Figur 3 gezeigten organischen strahlungsemittierenden Bauelements mittels eines Verfahrens gemäß Figur 2 wurde im Verfahrensschritt A die erste Elektrode 1 aus strukturiertem ITO mit dem elektrischen Kontaktbereich 10 auf dem Glassubstrat 6 mit den Abmessungen 200 mal 200 Millimeter bereitgestellt.

Für den Verfahrensschritt B wurde in einem Vakuumrezipienten in ein mit Aluminiumoxid ausgekleidetes, elektrisch beheizbares Molybdänboot mit Deckel 500 Milligramm $Re_2O_7$ als Quelle für das zweite Material 52 eingefüllt. Eine ähnliche Quelle für das erste Material 51 wurde mit NPB vorbereitet. Anschließend wurde das Substrat 6 mit der ersten Elektrode 1 auf einem Substrathalter circa 60 Zentimeter entfernt von den Quellen befestigt. Über dem Substrat 6 mit der ersten Elektrode 1 wurde eine Substratblende angeordnet, die anfänglich geschlossen war. Die Quelle für das zweite Material 52 wies ebenfalls eine Blende in Form einer Lochblende auf.

Die Quelle für das erste Material 51 wurde auf eine Aufwachsrate von 1 Nanometer pro Sekunde, die Quelle für das zweite Material auf eine Aufwachsrate von 0,1 Nanometer pro Sekunde für ein Dotierverhältnis von 10 zu 1 eingestellt. Anschließend wurde die Substratblende vollständig geöffnet und es wurden kontrolliert über einen Substratschichtdickenmonitor insgesamt 30 Nanometer Rheniumheptoxid dotiertes NPB abgeschieden. Dafür was die Blende der Quelle für das zweite Material 52 zunächst vollständig geöffnet, um eine 5 Nanometer dicke Schicht mit einem gleichmäßigen Verhältnis des Anteils des zweiten Materials zum Anteil des ersten Materials abzuscheiden.

Danach wurde die Blende der zweiten Quelle geschlossen und mit einer Rate von 1 Millimeter pro Sekunde geöffnet, um ein zu den Randbereichen der ersten organischen funktionellen Schicht 31 abfallendes Verhältnis des Anteils des zweiten Materials 52 zum Anteil des ersten Materials 51 zu erreichen. Nach vollständiger Öffnung der Blende der zweiten Quelle war die erste organische funktionelle Schicht 31 fertig gestellt.

In weiteren Verfahrensschritten C und D wurden der aktive Bereich 4, die weitere organische funktionelle Schicht 3 und die zweite Elektrode 2 aufgebracht und die Schichtenfolge des organischen strahlungsemittierenden Bauelements wurde anschließend verkapselt.

Das derart hergestellte, als "Bottom-Emitter" ausgeführte organische strahlungsemittierende Bauelement zeigte eine homogene Leuchtintensität über die gesamte Abstrahlungsfläche.

Gemäß einem weiteren Beispiel wurde ein organisches strahlungsemittierendes Bauelement hergestellt, das als zweites Material 52 anstelle von Rheniumheptoxid $F_4TCNQ$ aufwies und das ebenfalls eine homogene Leuchtintensität über die gesamte Abstrahlungsfläche zeigte.

Alternativ zum gezeigten Beispiel in Figur 3 und dem in Verbindung damit beschriebenen Verfahren sowie auch in den weiteren Beispielen können auch die erste Elektrode 1 reflektierend und die zweite Elektrode 2 transparent oder beide Elektroden 1, 2 transparent ausgeführt sein. Darüber hinaus können die erste Elektrode 1 als Kathode und die zweite Elektrode 2 als Anode ausgebildet sein und die erste organische funktionelle Schicht 31 kann als Elektronentransportschicht ausgeführt sein, die ein erstes und zweites Material 51, 52 gemäß der Beschreibung im allgemeinen Teil aufweist. Weiterhin können die Elektroden 1, 2, die erste organische Schicht 31, der aktive Bereich 4 und die weitere organische Schicht 3 in umgekehrter Reihenfolge auf dem Substrat 6 angeordnet sein. Weiterhin können noch weitere organische funktionelle Schichten wie etwa Ladungsträgerblockierschichten aufgebracht werden. Der aktive Bereich 4 kann alternativ auch mehr oder weniger elektrolumineszierende Schichten aufweisen. Weist der erste elektrische Kontaktbereich 10 eine andere Anordnung als die in Figur 3 sowie in den folgenden Figuren gezeigte auf oder soll eine bestimmte Leuchtdichteverteilung erreicht werden, die verschieden von der beschriebenen möglichst homogenen Leuchtdichteverteilung ist, so kann die Verteilung des ersten und zweiten Materials 51, 52 in den Teilbereichen 30 der ersten organischen funktionellen Schicht 31 von der vorab beschriebenen abweichen. All dies gilt auch für die weiteren Ausführungsbeispiele, ohne dass bei diesen gesondert darauf hingewiesen werden müsste.

In Figur 4 ist ein organisches strahlungsemittierendes Bauelement gemäß einem weiteren Beispiel gezeigt, bei dem die erste organische funktionelle Schicht 31 mittels des vorab beschriebenen Aufdampfverfahrens aufgebracht wurde. Das in Figur 4 gezeigte organische strahlungsemittierende Bauelement weist zwischen dem aktiven Bereich 4 und der ersten organischen funktionellen Schicht 31 eine zweite organische funktionelle Schicht 32 mit dem ersten Material 51 auf. Die zweite organische funktionelle Schicht 32 ist dabei frei vom zweiten Material 52 und grenzt direkt an den aktiven Bereich 4 an. Durch die zweite organische funktionelle Schicht 32 kann eine Unterdrückung ("quenching") der Abstrahlung elektromagnetischer Strahlung im aktiven Bereich 4 durch die Charge-Transfer-Komplexe aus dem ersten Material 51 zusammen mit dem zweiten Material 52 in der ersten organischen funktionellen Schicht 31 vermieden werden, wodurch die Effizienz des organischen strahlungsemittierenden Bauelements verbessert werden kann.

Gemäß weiteren Ausführungsbeispielen wurden organische strahlungsemittierende Bauelemente als "Top-Emitter" mit dem jeweils prinzipiellen Aufbau der organischen strahlungsemittierenden Bauelementen der Figuren 3 und 4 hergestellt, bei denen die erste Elektrode 1 aus Aluminium und als Kathode ausgeführt war. Dazu wurde zunächst eine 150 Nanometer dicke Aluminiumschicht als erste Elektrode 1 auf dem Substrat 6 aufgedampft.

In analoger Weise zum vorab beschriebenen Verfahrensschritt B wurde in einem entsprechenden Verfahrensschritt B eine erste organische funktionelle Schicht 31 als Elektronentransportschicht aufgebracht, die als erstes Material 2,9-Dimethyl-4,7-diphenyl-1,10-phenanthrolin (BCP) und als zweites Material Cäsiumcarbonat aufwies.

In weiteren Verfahrensschritten C und D wurden der aktive Bereich 4, eine als Lochtransportschicht ausgebildete weitere funktionelle Schicht 3 und eine transparente, als Anode ausgebildete zweite Elektrode 2 aufgebracht.

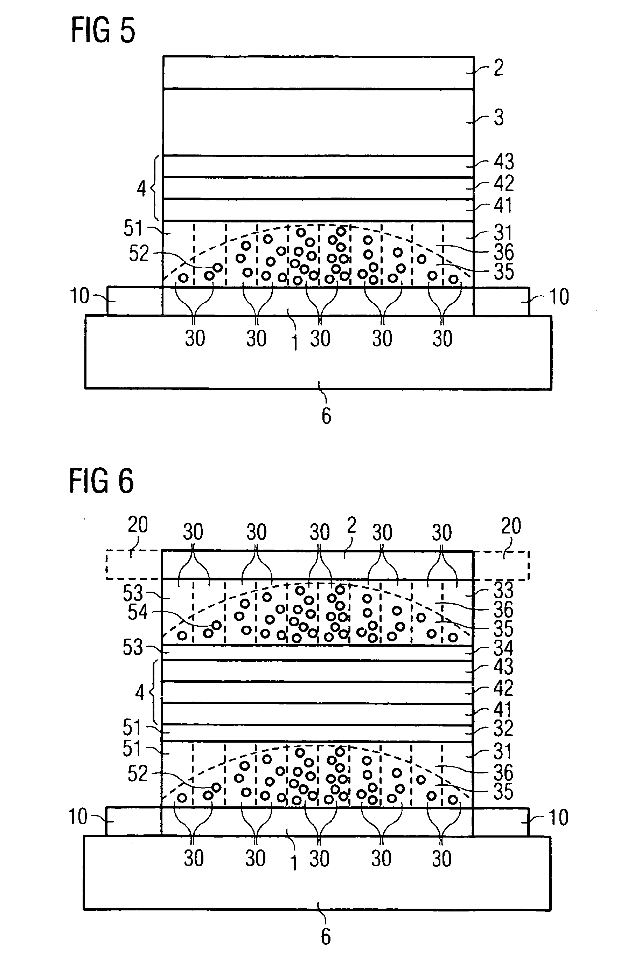

In Figur 5 ist ein organisches strahlungsemittierendes Bauelement gemäß einem Ausführungsbeispiel gezeigt.

Im Gegensatz zum organischen strahlungsemittierenden Bauelement in Figur 3 weist das Bauelement gemäß dem Ausführungsbeispiel in Figur 5 eine erste organische funktionelle Schicht 31 auf, bei dem jeder der Teilbereiche 30 einen ersten Funktionsbereich 35 und eine zweiten Funktionsbereich 36 aufweist, wie durch die gestrichelte Linie angedeutet ist. In jedem Teilbereich 30 weist dabei der erste Funktionsbereich 35 das erste und zweite Material 51 , 52 in einer gleichmäßigen Volumenkonzentration und Verteilung auf, während der zweite Funktionsbereich 36 nur das erste Material aufweist und frei vom zweiten Material ist. Weiterhin ist das Verhältnis des Anteils des zweiten Materials 52 zum Anteil des ersten Materials 51 in jedem der ersten Funktionsbereiche 35 gleich.

Der erste Funktionsbereich 35 und der zweite Funktionsbereich 36 eines jeden Teilbereichs 30 weist ein erstes Volumen beziehungsweise ein zweites Volumen auf. Die Teilbereiche 30 sind dabei derart ausgebildet, dass das Verhältnis des ersten Volumens zum zweiten Volumen mit steigendem lateralem Abstand zum ersten elektrischen Kontaktbereich größer wird. Dadurch kann erreicht werden, dass die Teilbereiche 30 in Abhängigkeit vom lateralen Abstand zum ersten elektrischen Kontaktbereich 10 einen steigenden Anteil des zweiten Materials 52 im Verhältnis zum Anteil des ersten Materials 51 aufweisen.

Mit anderen Worten bedeutet dies, dass die ersten Funktionsbereiche 35 der Teilbereiche 30 eine erste Funktionsschicht mit dem ersten und zweiten Material 51, 52 bilden, die mit steigendem lateralem Abstand zum ersten elektrischen Kontaktbereich 10 an Dicke zunimmt. Die zweiten Funktionsbereiche 36 der Teilbereiche 30 bilden entsprechend eine zweite Funktionsschicht, deren Dicke mit steigendem lateralem Abstand zum ersten elektrischen Kontaktbereich 10 an Dicke abnimmt. Dabei ist die Dicke der ersten organischen funktionellen Schicht 31 gleichmäßig dick und unabhängig vom lateralen Abstand zum ersten elektrischen Kontaktbereich 10. Dadurch kann sichergestellt werden, dass keine Farbverschiebungen durch mögliche unterschiedliche Kavitätseffekte aufgrund unterschiedlicher Abstände zwischen dem aktiven Beriech 4 und der ersten Elektrode 1 hervorgerufen werden.

In Figur 6 ist ein organisches strahlungsemittierendes Bauelement gemäß einem weiteren Ausführungsbeispiel gezeigt, das eine erste organische funktionelle Schicht 31 wie im vorangehenden Ausführungsbeispiel aufweist. Zusätzlich weist das hier gezeigte organische strahlungsemittierende Bauelement eine zweite organische funktionelle Schicht 32 auf, die nur das erste Material 51 aufweist.

Über dem aktiven Bereich 4 ist eine dritte organische funktionelle Schicht 33 mit einer Mehrzahl von lateral angeordneten Teilbereichen 30 mit einem dritten Material 53 mit einer dritten elektrischen Leitfähigkeit und einem vierten Material 54 mit einer vierten elektrischen Leitfähigkeit angeordnet. Dabei ist die vierte elektrische Leitfähigkeit größer als die dritte elektrische Leitfähigkeit. Die dritte organische funktionelle Schicht 33 ist hinsichtlich ihres Aufbaus analog zur ersten organischen funktionellen Schicht 31 ausgeführt und weist im gezeigten Ausführungsbeispiel ebenfalls erste Funktionsbereiche 35 mit dem dritten und vierten Material 53, 54 und zweite Funktionsbereiche 36 mit dem dritten Material auf. Die zweiten Funktionsbereiche 36 der dritten organischen funktionellen Schicht sind dabei frei vom vierten Material. Dadurch variiert auch in der dritten organischen funktionellen Schicht 33 das Verhältnis des Anteils des vierten Materials 54 zum Anteil des dritten Materials 53 in den Teilbereichen 30 in Abhängigkeit von einem lateralen Abstand zum ersten elektrischen Kontaktbereich 10 und/oder in Abhängigkeit von einem lateralen Abstand zu einem zweiten elektrischen Kontaktbereich 20 der zweiten Elektrode 2, der durch die gestrichelten Linien angedeutet ist.

Zwischen dem aktiven Bereich 4 und der dritten organischen funktionellen Schicht 33 ist eine vierte organische funktionelle Schicht 34 angeordnet, die das dritte Material 53 aufweist und die frei vom vierten Material 54 ist. Die vierte organische funktionelle Schicht grenzt direkt an den aktiven Bereich 4 an. Dadurch ist die vierte organische funktionelle Schicht 34 geeignet, ein mögliches "quenching" im aktiven Bereich 4 durch die Charge-Transfer-Komplexe des dritten Materials 53 zusammen mit dem vierten Material 54 zu vermeiden.

Das organische strahlungsemittierende Bauelement weist im gezeigten Ausführungsbeispiel als erstes und zweites Material 51, 52 NPB beziehungsweise $Re_2O_7$ und als drittes und viertes Materials 53, 54 BCP beziehungsweise Cäsiumcarbonat auf.

Das organische strahlungsemittierende Bauelement gemäß Figur 6 ist besonders geeignet, eine sehr große Abstrahlfläche mit einer homogenen Leuchtintensität zu ermöglichen, da es möglich ist, die partiellen Widerstände der möglichen Strompfade zwischen dem ersten elektrischen Kontaktbereich 10 und der zweiten Elektrode 2 beziehungsweise dem zweiten elektrischen Kontaktbereich 20 mittels der Verteilung des ersten und zweiten Materials 51, 52 in der ersten organischen funktionellen Schicht 31 sowie zusätzlich mittels des dritten und vierten Materials 53, 54 in der dritten organischen funktionellen Schicht 33 einzustellen.

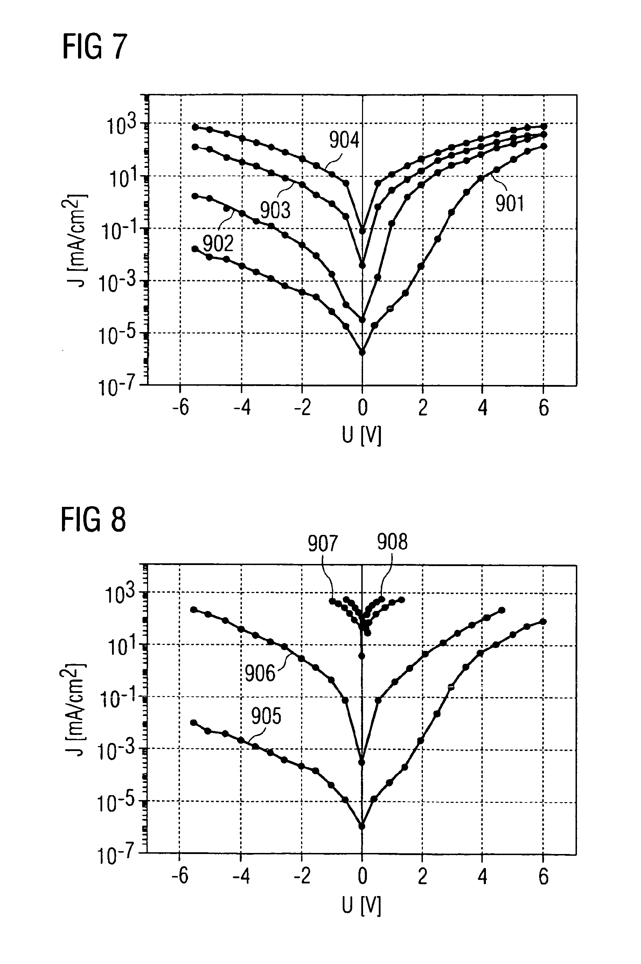

In den Figuren 7 und 8 sind Messkurven zu Stromdichten (in Milliampere pro Quadratzentimeter) in organischen funktionellen Schichten in Abhängigkeit von der jeweils angelegten Spannung (in Volt) dargestellt, die rein beispielhaft die Veränderung der elektrischen Leitfähigkeit in Abhängigkeit vom Verhältnis des Anteils des zweiten Materials zum Anteil des ersten Materials zeigen. In den gezeigten Messkurven erscheint es, als ob bei einer Spannung von 0 Volt jeweils endliche, von Null verschiedene Stromdichten erreichbar wären. Dabei handelt es sich jedoch um ein dem Fachmann bekanntes Messartefakt aufgrund der jeweiligen Messungenauigkeit und insbesondere aufgrund der halblogarithmischen Darstellung der Messkurven.

In den Messungen für beide Figuren 7 und 8 wurden 150 Nanometer dicke organische funktionelle Schichten hergestellt, die als erstes Material NPB aufwiesen.

Für die Messkurven in Figur 7 wurde $F_4TCNQ$ als zweites Material verwendet. Dabei zeigen die Messkurven 901, 902, 903 und 904 die jeweils erreichbaren Stromdichten für das erste Material alleine (901) und für ein Verhältnis des Anteils des zweiten Materials zum Anteil des ersten Materials von 1% (902), von 4% (903) und von 10% (904).

Für die Messkurven in Figur 8 wurde $MoO_3$ als zweites Material verwendet. Dabei zeigen die Messkurven 905, 906, 907 und 908 die jeweils erreichbaren Stromdichten für das erste Material alleine (905) und für ein Verhältnis des Anteils des zweiten Materials zum Anteil des ersten Materials von 1% (906), von 10% (907) und von 50% (908).

Aus beiden Figuren ist leicht erkennbar, dass durch ein steigendes Verhältnis des Anteils des zweiten Materials zum Anteil des ersten Materials eine steigende Stromdichte erreichbar ist, was an einem entsprechend sinkenden elektrischen Widerstand beziehungsweise einer steigenden elektrischen Leitfähigkeit liegt.

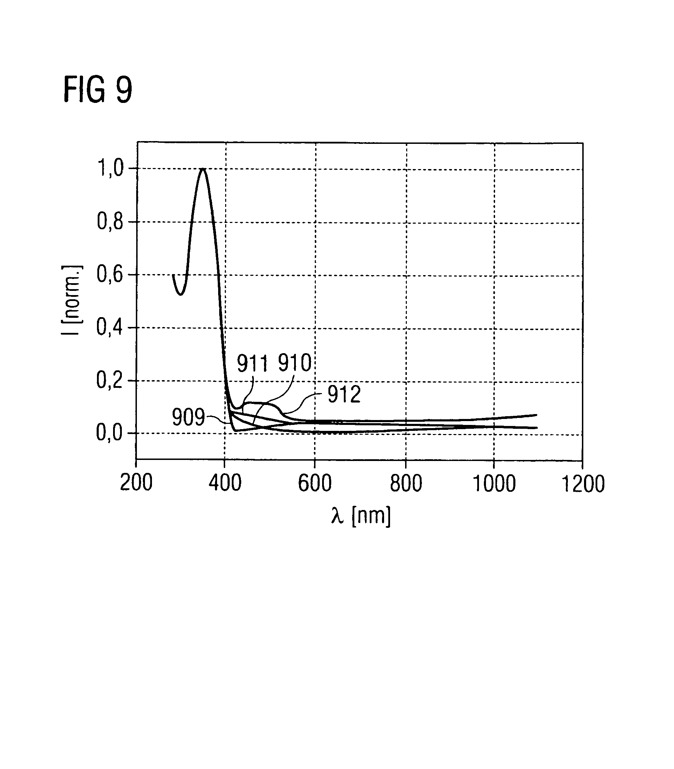

In Figur 9 sind Messkurven zur Transparenz (als normierte Intensität) von organischen funktionellen Schichten mit einem ersten und einem zweiten Material in Abhängigkeit von der Wellenlänge (in Nanometern) in einem ultravioletten bis infraroten Wellenlängenbereich gezeigt. Dazu wurde ein durch die organischen funktionellen Schichten transmittiertes UV-Spektrum gemessen.

Das erste Material war für alle Messungen NPB, während das zweite Material $Re_2O_7$ in verschiedenen Anteilen war. Die Messkurven 909, 910, 911 und 912 zeigen den jeweils transmittierten Anteil des UV-Spektrums für das erste Material alleine (909) und für ein Verhältnis des Anteils des zweiten Materials zum Anteil des ersten Materials von 1% (910), von 10% (911) und von 50% (912).

Aus den Messkurven 909, 910, 911 und 912 ist leicht erkennbar, das sich die Transparenz der organischen funktionellen Schichten in Abhängigkeit vom Verhältnis des Anteils des zweiten Materials zum Anteil des ersten Materials nur unwesentlich ändert, was in den oben beschriebenen organischen strahlungsemittierenden Bauelementen zu einem homogenen Leuchteindruck führen kann.

## Patentansprüche

1. Organisches strahlungsemittierendes Bauelement, umfassend:

   - eine erste Elektrode (1) mit einem ersten elektrischen Kontaktbereich (10) zur elektrischen Kontaktierung der ersten Elektrode (1),
   - auf der ersten Elektrode (1) eine erste organische funktionelle Schicht(31),
   - auf der ersten organischen funktionellen Schicht (31) zumindest einen organischen aktiven Bereich (4), der geeignet ist, im Betrieb elektromagnetische Strahlung abzustrahlen, und
   - auf dem aktiven Bereich (4) eine zweite Elektrode (2), wobei
   - die erste organische funktionelle Schicht (31) eine Mehrzahl von lateral angeordneten Teilbereichen (30) mit jeweils einem ersten Material (51) mit einer ersten elektrischen Leitfähigkeit und einem zweiten Material (52) mit einer zweiten elektrischen Leitfähigkeit umfasst,
   - die zweite elektrische Leitfähigkeit größer als die erste elektrische Leitfähigkeit ist und
   - das Verhältnis des Anteils des zweiten Materials (52) zum Anteil des ersten Materials (51) in den Teilbereichen (30) der ersten organischen funktionellen Schicht (31) in Abhängigkeit von einem lateralen Abstand zum ersten elektrischen Kontaktbereich (10) variiert,

   **dadurch gekennzeichnet, dass**

   - jeder der Teilbereiche (30) der ersten organischen funktionellen Schicht (31) einen ersten Funktionsbereich (35) mit dem ersten und dem zweiten Material (51, 52) und einen zweiten Funktionsbereich (36) mit dem ersten Material (51) aufweist,
   - die Volumenkonzentration des zweiten Materials (52) im Verhältnis zum ersten Material (51) in den ersten Funktionsbereichen (35) verschiedener Teilbereiche (30) gleich ist und
   - der zweite Funktionsbereich (36) der Teilbereiche (30) frei vom zweiten Material (52) ist.

2. Bauelement nach Anspruch 1, wobei

   - das Verhältnis des Anteils des zweiten Materials (52) zum Anteil des ersten Materials (51) mit steigendem lateralem Abstand zum ersten elektrischen Kontaktbereich (10) größer wird.

3. Bauelement nach dem vorherigen Anspruch, wobei

   - der erste Funktionsbereich (35) ein erstes Volumen und der zweite Funktionsbereich (36) ein zweites Volumen aufweist und

- das Verhältnis des ersten Volumens zum zweiten Volumen mit steigendem lateralem Abstand zum ersten elektrischen Kontaktbereich (10) größer wird.

4. Bauelement nach einem der vorherigen Ansprüche, wobei

- das erste Material (51) ein organisches elektrisch leitendes Matrixmaterial aufweist und
- das zweite Material (52) als Dotierstoff im ersten Material (51) eingebracht ist.

5. Bauelemente nach einem der vorherigen Ansprüche, wobei

- das erste und zweite Material (51, 52) zusammen Charge-Transfer-Komplexe bilden.

6. Bauelement nach dem vorherigen Anspruch, wobei

- die Charge-Transfer-Komplexe zumindest teilweise transparent für die im aktiven Bereich (4) erzeugte elektromagnetische Strahlung sind.

7. Bauelement nach einem der vorherigen Ansprüche, wobei

- zwischen der ersten organischen funktionellen Schicht (31) und dem aktiven Bereich (4) eine zweite organische funktionelle Schicht (32) mit dem ersten Material (51) angeordnet ist, die frei vom zweiten Material (52) ist und direkt an den aktiven Bereich (4) angrenzt.

8. Bauelement nach einem der vorherigen Ansprüche, wobei

- die erste organische funktionelle Schicht (31) als Lochtransportschicht und/oder als Elektronentransportschicht ausgebildet ist.

9. Bauelement nach einem der vorherigen Ansprüche, wobei

- die zweite Elektrode (2) einen zweiten elektrischen Kontaktbereich (20) zur elektrischen Kontaktierung der zweiten Elektrode (2) aufweist und
- zwischen dem aktiven Bereich (4) und der zweiten Elektrode (2) eine dritte organische funktionelle Schicht (33) angeordnet ist,

wobei

- die dritte organische funktionelle Schicht (33) eine Mehrzahl von lateral angeordneten Teilbereichen (30) mit jeweils einem dritten Material (53) mit einer dritten elektrischen Leitfähigkeit und einem vierten Material (54) mit einer vierten elektrischen Leitfähigkeit umfasst,
- die vierte elektrische Leitfähigkeit größer als die dritte elektrische Leitfähigkeit ist und
- das Verhältnis des Anteils des vierten Materials (54) zum Anteil des dritten Materials (53) in den Teilbereichen (30) der dritten organischen funktionellen Schicht (33) in Abhängigkeit von einem lateralen Abstand zum ersten elektrischen Kontaktbereich (10) und/oder in Abhängigkeit von einem lateralen Abstand zum zweiten elektrischen Kontaktbereich (20) variiert.

10. Verfahren zur Herstellung eines organischen strahlungsemittierenden Bauelements nach einem der Ansprüche 1 bis 10, umfassend die Schritte:

A) Bereitstellen der ersten Elektrode (1) mit dem ersten elektrischen Kontaktbereich (10),
B) Aufbringen der ersten organischen funktionellen Schicht (31) umfassend die Mehrzahl der lateral angeordneten Teilbereiche (30) mit dem ersten und zweiten Material (51, 52),
C) Aufbringen des aktiven Bereichs (4) auf der ersten organischen funktionellen Schicht (31), und
D) Aufbringen der zweiten Elektrode (2) auf dem aktiven Bereich(31).

11. Verfahren nach Anspruch 11, bei dem

- im Verfahrensschritt B das erste und zweite Material (51, 52) derart aufgebracht werden, dass das Verhältnis des Anteils des zweiten Materials (52) zum Anteil des ersten Materials (51) mit steigendem Abstand zum ersten elektrischen Kontaktbereich (10) größer wird.

12. Verfahren nach Anspruch 11 oder 12, bei dem

   - im Verfahrensschritt B das zweite Material (52) mittels einer verstellbaren Blende aufgebracht wird.

13. Verfahren nach Anspruch 13, bei dem

   - die verstellbare Blende eine Lochblende ist.


**Claims**

1. Organic radiation-emitting component, comprising:

   - a first electrode (1) having a first electrical contact region (10) for making electrical contact with the first electrode (1),
   - a first organic functional layer (31) on the first electrode (1),
   - on the first organic functional layer (31) at least one organic active region (4) suitable for emitting electromagnetic radiation during operation, and
   - a second electrode (2) on the active region (4),
   wherein
   - the first organic functional layer (31) comprises a plurality of laterally arranged partial regions (30) each comprising a first material (51) having a first electrical conductivity and a second material (52) having a second electrical conductivity,
   - the second electrical conductivity is greater than the first electrical conductivity, and
   - the ratio of the proportion of the second material (52) to the proportion of the first material (51) in the partial regions (30) of the first organic functional layer (31) varies in a manner dependent on a lateral distance from the first electrical contact region (10), **characterized in that**
   - each of the partial regions (30) of the first organic functional layer (31) has a first functional region (35) comprising the first and the second material (51, 52) and a second functional region (36) comprising the first material (51),
   - the volume concentration of the second material (52) in relation to the first material (51) in the first functional regions (35) of different partial regions (30) is identical, and
   - the second functional region (36) of the partial regions (30) is free of the second material (52).

2. Component according to Claim 1, wherein

   - the ratio of the proportion of the second material (52) to the proportion of the first material (51) becomes greater as the lateral distance from the first electrical contact region (10) increases.

3. Component according to the preceding claim, wherein

   - the first functional region (35) has a first volume and the second functional region (36) has a second volume,
   - the ratio of the first volume to the second volume becomes greater as the lateral distance from the first electrical contact region (10) increases.

4. Component according to any of the preceding claims, wherein

   - the first material (51) comprises an organic electrically conductive matrix material, and
   - the second material (52) is introduced as a dopant in the first material (51).

5. Component according to any of the preceding claims, wherein

   - the first and second materials (51, 52) together form charge transfer complexes.

6. Component according to the preceding claim, wherein

- the charge transfer complexes are at least partly transparent to the electromagnetic radiation generated in the active region (4).

7. Component according to any of the preceding claims, wherein

- a second organic functional layer (32) comprising the first material (51) is arranged between the first organic functional layer (31) and the active region (4), said second organic functional layer being free of the second material (52) and directly adjoining the active region (4).

8. Component according to any of the preceding claims, wherein

- the first organic functional layer (31) is embodied as a hole transport layer and/or as an electron transport layer.

9. Component according to any of the preceding claims, wherein

- the second electrode (2) has a second electrical contact region (20) for making electrical contact with the second electrode (2), and
- a third organic functional layer (33) is arranged between the active region (4) and the second electrode (2),

wherein

- the third organic functional layer (33) comprises a plurality of laterally arranged partial regions (30) each comprising a third material (53) having a third electrical conductivity and a fourth material (54) having a fourth electrical conductivity,
- the fourth electrical conductivity is greater than the third electrical conductivity, and
- the ratio of the proportion of the fourth material (54) to the proportion of the third material (53) in the partial regions (30) of the third organic functional layer (33) varies in a manner dependent on a lateral distance from the first electrical contact region (10) and/or in a manner dependent on a lateral distance from the second electrical contact region (20).

10. Method for producing an organic radiation-emitting component according to any of Claims 1 to 10, comprising the following steps:

A) providing the first electrode (1) having the first electrical contact region (10),
B) applying the first organic functional layer (31) comprising the plurality of laterally arranged partial regions (30) comprising the first and second materials (51, 52),
C) applying the active region (4) on the first organic functional layer (31), and
D) applying the second electrode (2) on the active region (31).

11. Method according to Claim 11, wherein

- in method step B, the first and second materials (51, 52) are applied in such a way that the ratio of the proportion of the second material (52) to the proportion of the first material (51) becomes greater as the distance from the first electrical contact region (10) increases.

12. Method according to Claim 11 or 12, wherein

- in method step B, the second material (52) is applied by means of an adjustable diaphragm.

13. Method according to Claim 13, wherein

- the adjustable diaphragm is a pinhole diaphragm.

**Revendications**

1. Composant organique émetteur de.rayonnement comprenant :

- une première électrode (1) munie d'une première zone de contact électrique (10) pour l'établissement du contact électrique avec la première électrode (1),
- sur la première électrode (1), une première couche fonctionnelle organique (31),
- sur la première couche fonctionnelle organique (31), au moins une zone organique active (4) qui est adaptée pour, en fonctionnement, émettre un rayonnement électromagnétique, et
- sur la zone active (4), une deuxième électrode (2),
- la première couche fonctionnelle organique (31) comprenant une pluralité de zones partielles (30) disposées latéralement qui présentent respectivement un premier matériau (51) ayant une première conductivité électrique et un deuxième matériau (52) ayant une deuxième conductivité électrique,
- la deuxième conductivité électrique étant supérieure à la première conductivité électrique et
- le rapport entre la part du deuxième matériau (52) et la part du premier matériau (51) dans les zones partielles (30) de la première couche fonctionnelle organique (31) variant en fonction d'un écart latéral par rapport à la première zone de contact électrique (10),

**caractérisé en ce que**

- chacune des zones partielles (30) de la première couche fonctionnelle organique (31) présente une première zone fonctionnelle (35) avec le premier et le deuxième matériau (51, 52) et une deuxième zone fonctionnelle (36) avec le premier matériau (51),
- la concentration volumique du deuxième matériau (52) par rapport au premier matériau (51) dans les premières zones fonctionnelles (35) de différentes zones partielles (30) est identique et
- la deuxième zone fonctionnelle (36) des zones partielles (30) est dépourvue du deuxième matériau (52).

2. Composant selon la revendication 1, dans lequel

- le rapport entre la part du deuxième matériau (52) et la part du premier matériau (51) devient plus grand à mesure que l'écart latéral par rapport à la première zone de contact électrique (10) augmente.

3. Composant selon la revendication précédente, dans lequel

- la première zone fonctionnelle (35) présente un premier volume et la deuxième zone fonctionnelle (36) présente un deuxième volume et
- le rapport entre le premier volume et le deuxième volume devient plus grand à mesure que l'écart latéral par rapport à la première zone de contact électrique (10) augmente.

4. Composant selon l'une des revendications précédentes, dans lequel

- le premier matériau (51) présente un matériau matriciel organique électriquement conducteur et
- le deuxième matériau (52) est introduit dans le premier matériau (51) en tant que substance de dopage.

5. Composant selon l'une des revendications précédentes, dans lequel

- le premier et le deuxième matériau (51, 52) forment ensemble des complexes de transfert de charge.

6. Composant selon l'une des revendications précédentes, dans lequel

- les complexes de transfert de charge sont au moins partiellement transparents pour le rayonnement électromagnétique généré dans la zone active (4).

7. Composant selon l'une des revendications précédentes, dans lequel

- entre la première couche fonctionnelle organique (31) et la zone active (4) est disposée une deuxième couche fonctionnelle organique (32) qui présente le premier matériau (51), laquelle est dépourvue du deuxième matériau (52) et directement contiguë à la zone active (4).

8. Composant selon l'une des revendications précédentes, dans lequel

- la première couche fonctionnelle organique (31) est réalisée sous la forme d'une couche de transport de trous et/ou d'une couche de transport d'électrons.

**9.** Composant selon l'une des revendications précédentes, dans lequel

- la deuxième électrode (2) présente une deuxième zone de contact électrique (20) pour l'établissement du contact électrique avec la deuxième électrode (2) et
- entre la zone active (4) et la deuxième électrode (2) est disposée une troisième couche fonctionnelle organique (33)
- la troisième couche fonctionnelle organique (33) comprenant une pluralité de zones partielles (30) disposées latéralement qui présentent respectivement un troisième matériau (53) ayant une troisième conductivité électrique et un quatrième matériau (54) ayant une quatrième conductivité électrique,
- la quatrième conductivité électrique étant supérieure à la troisième conductivité électrique et
- le rapport entre la part du quatrième matériau (54) et la part du troisième matériau (53) dans les zones partielles (30) de la troisième couche fonctionnelle organique (33) variant en fonction d'un écart latéral par rapport à la première zone de contact électrique (10) et/ou en fonction d'un écart latéral par rapport à la deuxième zone de contact électrique (20).

**10.** Procédé de fabrication d'un composant organique émetteur de rayonnement selon l'une des revendications 1 à 10, comprenant les étapes suivantes :

A) mise à disposition de la première électrode (1) munie de la première zone de contact électrique (10),
B) application de la première couche fonctionnelle organique (31) comprenant la pluralité des zones partielles (30) disposées latéralement qui présentent les premier et deuxième matériaux (51, 52),
C) application de la zone active (4) sur la première couche fonctionnelle organique (31), et
D) application de la deuxième électrode (2) sur la zone active (31).

**11.** Procédé selon la revendication 11, selon lequel

- dans l'étape de procédé B, les premier et deuxième matériaux (51, 52) sont appliqués de telle sorte que le rapport entre la part du deuxième matériau (52) et la part du premier matériau (51) devient plus grand à mesure que l'écart par rapport à la première zone de contact électrique (10) augmente.

**12.** Procédé selon la revendication 11 ou 12, selon lequel

- dans l'étape de procédé B, le deuxième matériau (52) est appliqué à l'aide d'un masque positionnable.

**13.** Procédé selon la revendication 13, selon lequel

- le masque positionnable est un masque perforé.

FIG 1

FIG 2

FIG 3

FIG 4

## FIG 5

## FIG 6

## FIG 7

## FIG 8

FIG 9

**EP 2 340 578 B1**

**IN DER BESCHREIBUNG AUFGEFÜHRTE DOKUMENTE**

**In der Beschreibung aufgeführte Patentdokumente**

- DE 102008054219
- WO 2006077136 A2
- US 20070075636 A1
- WO 2008034405 A1